# EUROPEAN PATENT SPECIFICATION

(11) **EP 1 767 994 B1**
(45) Date of publication and mention of the grant of the patent: **28.04.2010**
(21) Application number: 06020269.4
(22) Date of filing: 27.09.2006
(51) Int. Cl.: G03F 7/11

(54) **Planographic printing plate precursor**
Flachdruckplattenvorläufer
Précurseur de plaque d'impression planographique

(30) Priority: 27.09.2005 JP 2005279197
(43) Date of publication of application: 28.03.2007
(73) Proprietor: FUJIFILM Corporation, Minato-ku Tokyo (JP)
(72) Inventor: Koizumi, Shigeo c/o Fuji Photo Film Co.,Ltd., Shizuoka-ken (JP)
(74) Representative: HOFFMANN EITLE

(56) References cited:
- EP-A- 1 552 923
- US-A- 5 677 110
- US-A- 5 997 993

## Description

### Background of the Invention

### Field of the Invention

The present invention relates to a negative-type planographic printing plate precursor which can be directly delineated with infrared laser light and from which a plate can be made rapidly.

### Description of the Related Art

Conventionally, as a planographic printing plate precursor, a PS plate having a structure in which a lipophilic photosensitive resin layer is provided on a hydrophilic support has been widely used. As a plate-making method, usually, a desired printing plate is obtained by dissolving and removing a non-image part after mask exposure via a lith film (plane exposure). In recent years, the digitalizing technique of electronically processing, storing and outputting image information using a computer has become widespread. And, various new image outputting methods corresponding to such digitalizing techniques have been put to practical use. As a result, there has been a strong desire for Computer To Plate (CTP) technique of scanning light having high directivity such as laser light according to digitalized image information, and directly making a printing plate without use of a lith film. Therefore, it has become an important technical issue to obtain a planographic printing plate precursor adapted for such use.

As such a planographic printing plate precursor which can be scanned and exposed, a structure in which a lipophilic photosensitive resin layer (hereinafter, also referred to as "photosensitive layer") containing a photosensitive compound capable of generating active species such as radical and Brønsted acid by laser exposure is provided on a hydrophilic support has been proposed. A negative-type planographic printing plate can be obtained by scanning this planographic printing plate precursor based on digital information to generate an active species, causing a physical or chemical change on a photosensitive layer by its action to insolubilize this, followed by developing treatment.

Particularly, a planographic printing plate precursor in which a photopolymerization-type photosensitive layer containing a photopolymerization initiator excellent in photosensitive speed, an addition-polymerizable ethylenic unsaturated compound, and a binder polymer soluble in an alkali developer and, if necessary, an oxygen-shielding protective layer are provided on a hydrophilic support (e.g. see Japanese Patent Application Laid-Open (JP-A) No. 10-228109) has advantages in that the precursor is excellent in productivity, is simple in developing treatment, and has better resolution and inking property, and therefore, has desirable printing performance.

In addition, to improve productivity, that is, to improve plate-making speed, there has been proposed a recording material requiring no heating treatment after image-like exposure, using a photopolymerizable composition comprising a cyanine pigment having a particular structure, an iodonium salt, and an addition-polymerizable compound having an ethylenic unsaturated double bond in a photosensitive layer (for example, see Japanese Patent Application Publication (JP-B) No. 7-103171). However, this recording material has a problem in that polymerization inhibition occurs due to oxygen in the air during polymerization reaction, sensitivity is reduced, and strength of a formed image part is insufficient.

As a solution to this problem, a method of providing a protective layer containing a water-soluble polymer on a photosensitive layer is known. By the presence of a protective layer, polymerization inhibition is prevented, a reaction of curing a photosensitive layer is promoted, and it becomes possible to improve the strength of an image part.

However, when oxygen permeability of a protective layer is too low, dark polymerization progresses due to heat from long-term storage of a planographic printing plate precursor, resulting in a cause for deterioration in developing processibility and printing pollution. In addition, when a photosensitive planographic printing plate precursor is handled under indoor illumination, fog (safe light fog referred to in visible light photosensitive material; hereinafter, referred to as "safe light fog") occurs in some cases due to unintended exposure resulting from lower illuminance and longer indoor illumination light as compared with laser exposure.

In order to prevent such a problem by controlling oxygen permeability of a protective layer, a method of providing a protective layer containing at least one kind of polyvinylpyrrolidone and a copolymer of vinylpyrrolidone and vinyl acetate, and having a controlled film weight of 0.5 g/m² to 2.30 g/m² (see JP-A No. 2005-121863) is known.

However, a protective layer containing a polyvinylpyrrolidone-based polymer has a problem in that when hygroscopicity is increased, this increases dependency of oxygen permeability of a protective layer on humidity, and when humidity is increased during storage, adhesion between a protective layer surface and an adjacent set-off sheet or a plate material back occurs. In addition, a polyvinylpyrrolidone-based polymer easily remains on a photosensitive layer surface having a hydrophobic surface at an image part after developing treatment and, when developing treatment is performed for a long time using an automatic developing machine, polyvinylpyrrolidone remains on a photosensitive layer surface in some cases. When polyvinylpyrrolidone remains on an image part surface, a problem of considerable decrease in inking property at an image part occurs.

Due to the above circumstances, there has been a demand for a planographic printing plate precursor which is a photopolymerization planographic printing plate precursor having an oxygen-permeable protective layer suppressing polymerization inhibition of a photosensitive layer, having little dark polymerization at storage with time, and not causing safe light fog due to illumination light during plate-making and, as described above, not causing a problem of adhesion of a protective layer surface under high humidity storage conditions, and a problem such as reduction in inking property.

US-A-5 997 993 and US-A-5 677 110 discloses planographic printing of plate having a protective layer containing PVA and a copolymer of ethylene oxide and propylene oxide.

EP-A-1 552 923 discloses a lithographic printing plate precursor having a protective layer containing PVA.

### Summary of the Invention

An object of the present invention is to solve the conventional problems, and attain the above object.

That is, an object of the invention is to provide a planographic printing plate precursor which can be written with an infrared laser, and has a protective layer, and can improve productivity in plate-making work.

More specifically, an object of the invention is to provide a planographic printing plate precursor provided with a protective layer which suppresses polymerization inhibition of a photosensitive layer, moreover, does not cause fog at long term storage and safe light fog, is excellent in development removability, further, suppresses adhesion between a surface of a protective layer of a planographic printing plate precursor and an adjacent set-off sheet or a surface on a support side of a planographic printing plate precursor even when planographic printing plate precursors are stacked, and is better in inking property even at long term treatment with an automatic developing machine, on a photosensitive layer which can be written with an infrared laser.

In addition, an object of the invention to provide a planographic printing plate precursor with a protective layer which improves a rubbing flaw.

According to an aspect of the invention, a planographic printing plate precursor in which a photosensitive layer and a protective layer are successively laminated on a surface of an aluminum support exhibiting hydrophilicity, characterized in that the protective layer contains a binder polymer, and a copolymer of ethylene oxide and propylene oxide is provided.

### Detailed Description of the Invention

In order to attain the aforementioned objects, the present inventors intensively continued to study and, as a result, found out that, by making a protective layer contain polyvinyl alcohol having a defined range of a saponification degree, and a copolymer of ethylene oxide and propylene oxide, the above objects can be attained, which resulted in completion of the invention.

That is, the planographic printing plate precursor of the present invention is a planographic printing plate precursor as claimed in claim 1.

The phrase "laminated on a support in this order" means that a photosensitive layer and a protective layer are arranged on a support in this order, but this phrase does not deny the presence of other layers (for example, an intermediate layer, a back coat layer, etc.) arranged in accordance with specific objectives.

The binder polymer contained in the protective layer is a polyvinyl alcohol having a saponification degree of 91 mole% or more.

The content of the polyvinyl alcohol having a saponification degree of 91 mol% or more is 45 to 95 % by mass relative to a total solid matter amount of a protective layer.

It is preferable that a content of ethylene oxide contained in a copolymer of ethylene oxide and propylene oxide contained in the protective layer is 30 to 80 % by mass.

In the planographic printing plate precursor of the invention, it is preferable that oxygen permeability of a protective layer under environment of 25°C, 60 %RH and 1 atm is 0.5 ml/m²·day or more and 100 ml/m²·day or less.

Further, in the planographic printing plate precursor of the invention, it is preferable that the photosensitive layer contains an infrared absorbing agent, a polymerization initiator, a polymerizable compound and a binder polymer, and the binder polymer is a binder polymer having a repetition unit represented by the following formula (i).

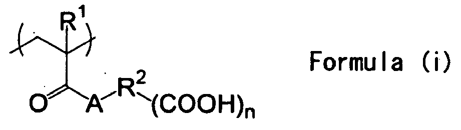

(In the formula (i), R¹ represents a hydrogen atom or a methyl group, R² represents a tethering group containing 2 or more atoms selected from the group consisting of a carbon atom, a hydrogen atom, an oxygen atom, a nitrogen atom, and a sulfur atom, and having the number of those atoms of 2 to 82, A represents an oxygen atom or -NR³-, R³ represents a hydrogen atom or a monovalent hydrocarbon group of a carbon number of 1 to 10, and n represents an integer of 1 to 5)

Although action of the invention is not clear, the following is presumed.

Since a protective layer in the invention contains a binder polymer, and a copolymer of ethylene oxide and propylene oxide, a film strength is improved, and a surface of low adherability is formed. Further, this protective layer has proper oxygen permeability. From them, when planographic printing plate precursors having this protective layer are laminated, it is presumed that, adhesion between a protective layer constituting a surface on a photosensitive layer side of a planographic printing plate precursor, and an adjacent set-off sheet or a surface on a support side of a planographic printing plate precursor is suppressed, and a rubbing flaw generated between a protective layer surface and an aluminum support back, and a flaw of a protective layer due to a trash and a sand particle can be suppressed and, at the same time, storing property with time and safe light suitability are excellent, and occurrence of deteriorated inking can be suppressed.

According to the invention, a planographic printing plate precursor which can be written with an infrared laser, has better inking property, and has a protective layer excellent in flaw resistance can be provided.

More specifically, according to the invention, a planographic printing plate precursor provided with a protecting layer which suppresses polymerization inhibition of a photosensitive layer, is better in safe light suitability and storing property with time, is excellent in development removability and inking property, further, suppresses adhesion between a surface of a protective layer of a planographic printing plate precursor and an adjacent set-off sheet or a surface on a support side of a planographic printing plate precursor even when planographic printing plate precursors are stacked, and can improve a rubbing flaw generated between a protective layer surface and an aluminum support back, and a flaw of a protective layer due to a trash and a sand particle, on a photosensitive layer which can be written with a laser, is provided.

### <<Planographic printing plate precursor>>

The planographic printing plate precursor of the invention is a planographic printing plate precursor in which a photosensitive layer containing an infrared absorbing agent, a polymerization initiator, a polymerizable compound and a binder polymer, and a protective layer are successively laminated on a surface of an aluminum support exhibiting hydrophilicity, the protective layer is as defined in claim 1.

Each constitutional element constituting the planographic printing plate precursor of the invention will be explained below.

### <Protective layer>

The protective layer in the invention is characterized in that the layer contains polyvinyl alcohol having a saponification degree of 91 mol% or more (hereinafter, conveniently, referred to as "specified polyvinyl alcohol"), and a copolymer of ethylene oxide and propylene oxide.

Since in the planographic printing plate precursor of the invention, a photosensitive layer is a polymerizable negative-type photosensitive layer (described later), a protective layer is disposed on the photosensitive layer for the purpose of preventing mixing in of a low-molecular compound such as oxygen, moisture, and basic substance present in the air which inhibits an image forming reaction, into the photosensitive layer, usually for performing light exposure in the air.

By making a protective layer disposed for such the purpose contain specified polyvinyl alcohol, and a copolymer of ethylene oxide and propylene oxide, it becomes possible to optimally control oxygen permeability, and improvement in a sensitivity, improvement in storing property with time, and improvement in safe light suitability can be attained without reducing inking property. Also, an excellent film strength can be attained. As a result, a protective layer can attain not only the aforementioned improvement in sensitivity, but also improvement in storing property with time, and improvement in safe light suitability without reducing inking property, and has become possible to suppress deterioration due to deformation and occurrence of a flaw. Further, when planographic printing plate precursors of the invention are stacked, it becomes possible to suppress adhesion between a set-off sheet or a surface of a protective layer of a planographic printing plate precursor and an adjacent back of a support of a planographic printing plate precursor.

Specified polyvinyl alcohol, and a copolymer of ethylene oxide and propylene oxide will be explained below.

### (Specified polyvinyl alcohol)

As in the invention, fundamental property desired on a protective layer disposed on a polymerizable negative-type photosensitive layer is that permeation of light used in exposure is not substantially inhibited, suitable oxygen permeability is possessed, and adherability with a photosensitive layer is excellent, but its surface is low adhering, and can be easily removed in a developing step after exposure.

In order to obtain fundamental property desired on such the protecting layer, the invention is characterized in that, as a binder component of a protective layer, polyvinyl alcohol having a saponification degree of 91 mol% or more (specified polyvinyl alcohol) is used. This specified polyvinyl alcohol has a surface excellent in film forming property and having relatively low adherability.

Polyvinyl alcohol having a saponification degree of 91 mol% or more used in the invention may be such that a part of it may be substituted with ester, ether or acetal, or a part of it may be modified and, further, similarly, a part of it may have other copolymerization component, as far as it has an unsubstituted vinyl alcohol unit for having necessary oxygen shielding property and low adhering surface if a saponification degree is in the above range.

Generally, as a saponification degree of PVA used is higher (as a content of an unsubstituted vinyl alcohol unit in a protective layer is higher), oxygen shielding property becomes higher, and this is advantageous in a sensitivity. For this reason, in a protective layer in the invention, for example, by using a mica compound described later together with polyvinyl alcohol having a saponification degree of 91 mol% or more, a film strength of a protective layer is further improved, and flaw resistance and oxygen shielding property can be enhanced.

It is preferable that such the specified polyvinyl alcohol has a polymerization degree in a range of 200 to 2400.

Specifically, examples include PVA-102, PVA-103, PVA-104, PVA-105, PVA-110, PVA-117, PVA-120, PVA-124, PVA-117H, PVA-135H, PVA-HC, PVA-617, PVA-624, PVA-706, PVA-613, PVA-CS, and PVA-CST manufactured by Kuraray Co., Ltd., Gosenol NL-O5, NM-11, NM-14, AL-06, P-610, C-500, A-300, and AH-17 manufactured by Nippon Synthetic Chemical Industry Co., Ltd., and JF-04, JF-05, JF-10, JF-17, JF-17L, JM-05, JM-10, JM-17, JM-17L, JT-05, JT-13, and JT-15 manufactured by Japan Vam & Poval Co., Ltd.

Examples of specified polyvinyl alcohol in the invention include carboxy-modified polyvinyl alcohol such as itaconic acid or maleic acid-modified polyvinyl alcohol, and sulfonic acid-modified polyvinyl alcohol as a preferable example as far as it has a saponification degree of 91 mol% or more.

Examples of acid-modified polyvinyl alcohol suitable as such the specified polyvinyl alcohol include KL-118, KM-618, KM-118, SK-5102, MP-102, and R-2105 manufactured by Kuraray Co., Ltd., Gosenal CKS-50, T-HS-1, T-215, T-350, T-330, and T-330H manufactured by Nippon Synthetic Chemical Industry Co., Ltd., and AF-17, and AT-17 manufactured by Japan Vam & Poval Co., Ltd.

The specified polyvinyl alcohol is contained at preferably in a range of 45 to 95 % by mass, more preferably in a range of 50 to 90 % by mass relative to a total solid matter amount in a protective layer. When the content is less than 45 % by mass, film forming property is insufficient, and a sensitivity is reduced and, when the content exceeds 95 % by mass, the effect of suppressing adhesion between stacked planographic printing plate precursors is manifested with difficulty.

As the specified polyvinyl alcohol, at least one kind may be used, or a plurality of the specified polyvinyl alcohols may be used. Also when a plurality of kinds of specified polyvinyl alcohols are used together, an amount of a sum thereof is preferably in the aforementioned mass range.

### (Copolymer of ethylene oxide and propylene oxide)

The copolymer of ethylene oxide and propylene oxide in the invention functions as an oxygen permeation controlling agent for a protective layer.

Specified polyvinyl alcohol which is a main component constituting a protective layer in the invention has a high saponification degree (91 mol% or more), and has low oxygen permeability. For this reason, flaw resistance, and adhesion resistance are very excellent but there is a problem of increase in fog at storage with time, and deterioration in safe light suitability, accompanying with low oxygen permeability. When a copolymer of ethylene oxide and propylene oxide is added to such the protective layer, excellent flaw resistance can be obtained and, at the same time, oxygen permeability can be improved without deteriorating property of adhesion resistance.

Herein, it is well known that polyvinyl alcohol forms an excellent oxygen shielding film by hydrogen bond between -OH groups contained in the polyvinyl alcohol. Therefore, as a simplest method of improving oxygen permeability of a polyvinyl alcohol film, a method of using polyvinyl alcohol having a small content of an -OH group, having a high copolymerization ratio of a vinyl acetate group which is a large side chain inhibiting crystallization, and having a low saponification degree is contemplated. However, when a copolymerization ratio of a vinyl acetate group grows larger, not only oxygen permeability but also adherability of a protective layer surface is increased and, when many planographic printing plate precursors having such the protective layer are stacked, and stored, adhesion occurs between a protective layer surface and a set-off sheet or an A1 support of a back of a planographic printing plate, and a trouble such as two sheet conveyance at conveyance of printing plates, and a problem of a peeling flaw of a protective layer film are caused.

As other method of improving oxygen permeability of a polyvinyl alcohol film, a method of adding a plasticizer to a polyvinyl alcohol material is known. Examples of a well-known plasticizer of polyvinyl alcohol include glycerin, diethylene glycol, triethylene glycol, propylene glycol, 2,3-butanediol, 1,3-butanediol, trimethylene glycol, tetramethylene glycol, pentamethylene glycol, hexamethylene glycol, and trimethylolpropane. However, there is a problem that control of oxygen permeability by adding these low-molecular plasticizers all causes deterioration in adherability of a protective layer film.

Further, as other method of improving oxygen permeability of a polyvinyl alcohol film, there is a method of mixing other water-soluble polymer into polyvinyl alcohol. As such the water-soluble polymer, polyvinylpyrrolidone, polyethylene glycol, soluble starch, carboxymethylcellulose, and hydroxyethylcellulose are known. Among them, since polyvinylpyrrolidone has a pyrrolidone group having a large volume on a side chain, the effect of inhibiting crystallization of polyvinyl alcohol is great. Although polyvinylpyrrolidone is known to be effective, there is a problem that a protective layer containing a polyvinylpyrrolidone-based polymer has increased hygroscopicity, increases dependency of oxygen permeability of a protective layer on a humidity and, when a humidity is increased at storage, adhesion is caused between a protective layer surface and an adjacent set-off sheet or a printing material back. In addition, a polyvinylpyrrolidone-based polymer easily remains on a surface of a photosensitive layer having a hydrophobic surface at an image part after developing treatment and, when long term developing treatment is performed using an automatic developing machine, polyvinylpyrrolidone remains on a surface of a photosensitive layer in some cases. When polyvinylpyrrolidone remains on a surface of an image part, inking property at an image part is considerably reduced. On the other hand, it was seen that addition of cellulose or a starch-based oligomer having many -OH groups in a molecule has not considerable effect of increasing oxygen permeability.

Then, the present inventors confirmed of addition of various water-soluble polymers and oligomers, and found out that by further adding a copolymer of ethylene oxide and propylene oxide to a protective layer containing polyvinyl alcohol having a saponification degree of 91 mol% or more, excellent flaw resistance can be obtained and, at the same time, oxygen permeability can be improved at a small addition amount without deteriorating property of adhesion resistance, which resulted in completion of the invention.

The copolymer of ethylene oxide and propylene oxide used in the invention is preferably a compound represented by the formula:

HO-(CH₂CH₂O)ₐ(C₃H₆O)_{b}(CH₂CH₂O)_{c}-H.

In the formula, a, b and c represent an integer of 1 or more, and it is further preferable that a molecular weight of the compound represented by the formula is in a range of 2,000 to 27,000.

Specifically, examples include polyether-type polymer nonionic surfactants manufactured by USA Wine dot (Pluronic series), Pluronic series (ethylene oxide/propylene oxide copolymers; Pluronic P-84, L-64, P-85, F-88, P-94, P-75, P-65, F-77) manufactured by ADEKA CORPORATION.

Such the Pluronics function as a surfactant, an ethylene oxide part is a hydrophilic group, and a propylene oxide part is a hydrophilic group, and their property can be freely regulated by a molecular weight of a propylene oxide part and an addition amount of ethylene oxide.

A copolymer suitably used as a copolymer of ethylene oxide and propylene oxide contained in a protective layer of the planographic printing plate precursor of the invention is such that a content of ethylene oxide contained in the copolymer of ethylene oxide and propylene oxide is 30 % by mass or more, preferably in a range of 30 % by mass or more and 80 % by mass or less, further preferably in a range of 30 % by mass or more and 60 % by mass or less.

When a content of ethylene oxide is less than 30 % by mass, water-solubility of the copolymer is low and, when mixed with polyvinyl alcohol in an aqueous solution, it is difficult to form a film as a protective layer.

When a content of ethylene oxide contained in a copolymer of ethylene oxide and propylene oxide is 30 % by mass or more, a weight average molecular weight of polypropylene oxide is preferably in a range of 950 or more and 3,250 or less, more preferably in a range of 1,200 or more and 3,250 or less.

An amount of a copolymer of ethylene oxide and propylene oxide contained in a protective layer of the planographic printing plate precursor of the invention is from 2.0 % to 15 % by mass relative to the total solid matter amount of a protective layer.

When a content is less than 1.0 % by mass, the effect of improving oxygen permeability of a protective layer is small and, when the content is greater than 20 % by mass, oxygen permeability of a protective layer becomes too great, and there is a problem that reduction in adhesion resistance and a film strength is resulted.

The reason why the effect of increasing oxygen permeability of a protective layer although an amount of a copolymer of ethylene oxide and propylene oxide to be contained in a protective layer is far smaller as compared with a content of specified polyvinyl alcohol relative to a total solid matter amount of a protective layer is not clear, but it is presumed to be due to crystallization inhibiting effect of specified polyvinyl alcohol, resulting from a bulky hydrophobic group at a propylene oxide part of the copolymer.

Components of a protective layer (selection of specified polyvinyl alcohol and a copolymer of ethylene oxide and propylene oxide, use of an additive), and a coating amount are selected in view of oxygen shielding property, development removality, fog property, adherability, and flaw resistance.

It is preferable that the protective layer in the invention has oxygen permeability at 25°C, 60 %RH and 1 atm of 0.5 ml/m²·day or more and, in order to attain this oxygen permeability, it is preferable to use a procedure of adjusting components of the protective layer, and a coating amount.

On the other hand, in the protective layer in the invention, adherability with an image part of a photosensitive layer, and uniformity of a film are also extremely important from a viewpoint of handling of a plate. That is, when a hydrophilic layer comprising a water-soluble polymer is laminated on a lipophilic photosensitive layer, film peeling easily occurs due to lack of an adhering force, and a peeled part causes a defect such as deteriorated film curing due to polymerization inhibition of oxygen. In response to this, in order to improve adherability between these two layers, there are many proposals. For example, US 4,072,527 and US 4,072,528 describe that sufficient adherability is obtained by mixing 20 to 60 % by mass of an acryl-based emulsion or a water-insoluble vinyl ester-vinyl acetate copolymer into a hydrophilic polymer containing mainly polyvinyl alcohol, and laminating this on a photosensitive layer.

These known techniques can be all applied to the protective layer in the invention in such a range that the effect of containing the specified polyvinyl alcohol and the copolymer of ethylene oxide and propylene oxide is not deteriorated.

Colorants (water-soluble dyes) which have high transmittance for light (infrared light in the invention) used to expose the photosensitive layer and can absorb the light having wavelengths which are not involved in exposure may be added in the protective layer according to the invention. The protective layer can be thereby improved in safe-light adaptability.

### (Formation of protective layer)

The protective layer in the invention is formed by coating a coating solution for a protective layer obtained by blending the specified polyvinyl alcohol, and a binder component (or an aqueous solution in which a binder component containing specified polyvinyl alcohol is dissolved) containing a copolymer of ethylene oxide and propylene oxide on a photosensitive layer.

Known additives such as surfactants improving coatability and water-soluble plasticizers improving the properties of the coating film may be added to this protective layer coating solution. Examples of the water-soluble plasticizer include propionamide, cyclohexanediol, glycerin and sorbitol. Also, a water-soluble (meth)acrylic polymer may also be added. Moreover, known additives that improve adhesion to the photosensitive layer and the stability of the coating solution with time may be added to this coating solution.

No particular limitation is imposed on the method of applying the protective layer according to the invention and the methods described in U.S. Patent No. 3,458,311 or JP-A No. 55-49729 may be applied.

A coating amount of the protective layer in the invention is from 0.3 g/m² to 3.0 g/m². When the amount is less than 0.1 g/m², a film strength of a protective layer cannot be maintained, and flaw resistance is deteriorated in some cases. On the other hand, when the amount exceeds 3.0 g/m², scattering of light introduced into a protective layer due to light exposure is generated, deterioration in image quality is caused, oxygen permeability is decreased too much, and safe light suitability is deteriorated in some cases.

### [Photosensitive layer]

The photosensitive layer of the planographic printing plate precursor according to the invention is a polymerizable negative type photosensitive layer containing an infrared absorber, a polymerization initiator, a polymerizable compound and a binder polymer as essential components, and as required, colorants and other optional components.

The polymerizable negative type photosensitive layer in the invention is sensitive to infrared light and is therefore photosensitive to an infrared laser useful for CTP. The infrared absorber contained in the photosensitive layer is put into an electronically excited state by infrared laser radiation (exposure) highly sensibly. Electronic transfer, energy transfer and heat generation (light-heat conversion function) relating to this electronically excited state act on the polymerization initiator coexisting in the photosensitive layer to cause a chemical change of the polymerization initiator to generate radicals.

Examples of radical-generation mechanisms include (1) a mechanism in which the heat generated by the light-heat conversion function of an infrared absorber thermally decomposes a polymerization initiator (e.g., a sulfonium salt) which will be explained later to generate radicals, (2) a mechanism in which excited electrons generated from an infrared absorber transfer to a polymerization initiator (e.g., an activated halogen compound) to generate radicals and (3) a mechanism in which electrons generated from a polymerization initiator (e.g., a borate compound) transfer to an excited infrared absorber to generate radicals. Then, a polymerizable compound is allowed to enter into a polymerization reaction by the generated radicals to cure the exposed portion, forming an image area.

The photosensitive layer contains the infrared absorber in the planographic printing plate precursor of the invention and the planographic printing plate precursor is therefore particularly suitable to plate-making in which an image is formed directly by an infrared laser having a wavelength of 750 nm to 1400 nm. The planographic printing plate precursor of the invention can develop higher image forming characteristics than conventional planographic printing plate precursors.

Each component contained in the photosensitive layer according to the invention will be explained hereinbelow.

### (Infrared absorber)

The photosensitive layer according to the invention contains an infrared absorber in order to develop an energy transfer function and a light-heat conversion function.

The infrared absorber is put into an electronic excited state highly sensibly by infrared laser radiation (exposure) and electronic transfer, energy transfer and heat generation (light-heat conversion function) relating to this electronically excited state act on the initiator which will be described later to cause a chemical change of the polymerization initiator to generate radicals.

The infrared absorber used in the invention is preferably a dye or a pigment having an absorption maximum at a wavelength in the range of 750 nm to 1400 nm.

The dye may be any known commercial dye including those described in publications such as Senryo Binran (Dye Handbook) (published in 1970 and compiled by the Society of Synthetic Organic Chemistry, Japan). Examples of such dyes include azo dyes, metal complex salt azo dyes, pyrazolone azo dyes, naphthoquinone dyes, anthraquinone dyes, phthalocyanine dyes, carbonium dyes, quinone imine dyes, methine dyes, cyanine dyes, squarylium dyes, pyrylium salts, and metal thiolate complexes.

Preferable dyes include cyanine dyes such as those described in patent documents such as JP-A Nos. 58-125246, 59-84356, 59-202829, and 60-78787, and the methine dyes described in JP-A Nos. 58-173696, 58-181690, 58-194595, etc. Further, the naphthoquinone dyes described in JP-A Nos. 58-112793, 58-224793, 59-48187, 59-73996, 60-52940, 60-63744, etc., the squarylium dyes described in JP-A No. 58-112792, etc., and the cyanine dyes described in Britsh Patent No. 434,875 are also preferably used.

A near infrared absorbing sensitizer described in USP No. 5,156,938 is also preferably used, and a substitute arylbenzo(thio)pyrylium salt described in USP No. 3,881,924, a trimethinethiapyrylium salt described in JP-A No. 57-142645 (USP No. 4,327,169), a pyrylium-based compound described in JP-A Nos. 58-181051, 58-220143, 59-41363, 59-84248, 59-84249, 59-146063, and 59-146061, a cyanine pigment described in JP-A No. 59-216146, a pentamethinethiopyrylium salt described in USA No. 4,283,475, and a pyrylium compound disclosed in JP-B Nos. 5,13514, and 5-19702 are also preferably used. Another preferable examples of a dye include near infrared absorbing dyes described as the formulas (I) and (II) in USP No. 4,756,993.

Other preferable examples of an infrared absorbing pigment in the invention include particular indoleninecyanine pigments described in JP-A No. 2002-278057 as exemplified below.

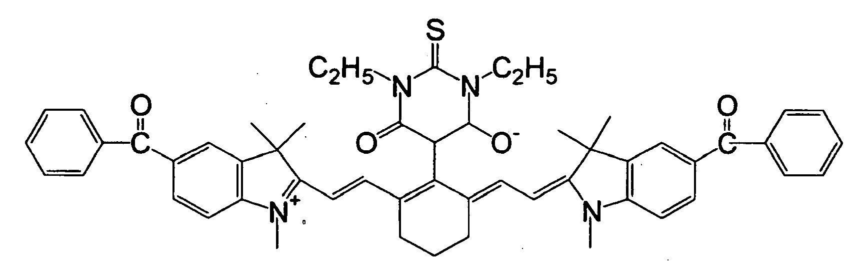

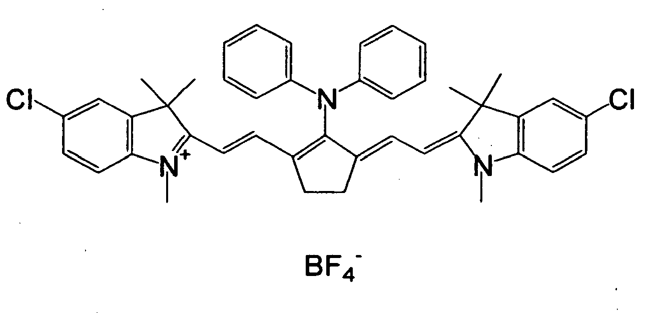

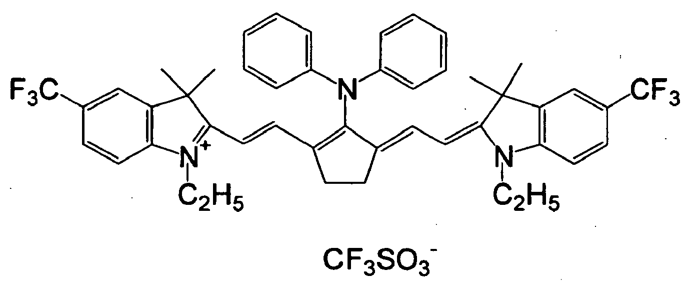

Particularly preferable among these dyes are cyanine dyes, squarylium dyes, pyrylium salts, nickelthiolate complexes and indolenine cyanine dyes. The dyes are more preferably cyanine dyes and indolenine cyanine dyes, still more preferably cyanine dyes represented by the formula (a).

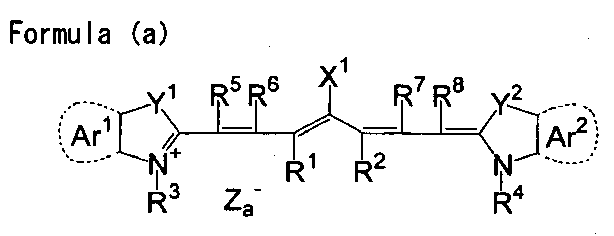

In the formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having 1 to 12 carbon atoms, an aromatic ring having a heteroatom, and a hydrocarbon group having 1 to 12 carbon atoms containing a heteroatom. The heteroatom refers to N, S, O, halogen atom or Se. Xa⁻ has the same meaning as that of Za⁻ defined later, and R^{a} represents a substituent group selected from a hydrogen atom, an alkyl group, an aryl group, a substituted or unsubstituted amino group, and a halogen atom.

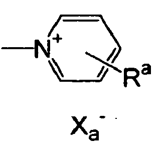

R¹ and R² independently represent a hydrocarbon group having 1 to 12 carbon atoms. For the purpose of storability of the coating solution of the recording layer, each of R¹ and R² is preferably a hydrocarbon group having 2 or more carbon atoms, and more preferably R¹ and R² are linked to each other to form a 5- or 6-memberred ring.

Ar¹ and Ar² may be the same or different and each represents an aromatic hydrocarbon group which may have a substituent group. The aromatic hydrocarbon group is preferably a benzene ring or a naphthalene ring. The substituent group is preferably a hydrocarbon group having 12 or less carbon atoms, a halogen atom or an alkoxy group having 12 or less carbon atoms. Y¹ and Y² may be the same or different and each represents a sulfur atom or a dialkyl methylene group having 12 or less carbon atoms. R³ and R⁴ may be the same or different and each represents a hydrocarbon group having 20 or less carbon atoms, which may have a substituent group. The substituent group is preferably an alkoxy group having 12 or less carbon atoms, a carboxyl group or a sulfo group. R⁵, R⁶, R⁷ and R⁸ may be the same or different and each represents a hydrogen atom or a hydrocarbon group having 12 or less carbon atoms. Each of R⁵, R⁶, R⁷ and R⁸ is preferably a hydrogen atom because the starting material is easily available. Za⁻ represents a counter anion. However, when the cyanine dye represented by the formula (a) has an anionic substituent group in its structure and does not necessitate neutralization of the charge, Za⁻ is not necessary. For the purpose of storability of the coating solution of the photosensitive layer, Za⁻ is preferably a halogen ion, a perchlorate ion, a tetrafluoroborate ion, a hexafluorophosphate ion or a sulfonate ion, particularly preferably a perchlorate ion, a hexafluorophosphate ion or an aryl sulfonate ion.

Examples of the cyanine dyes represented by the formula (a), which can be preferably used in the present invention, include those described in columns [0017] to [0019] in JP-A No. 2001-133969.

Other preferable examples of the infrared absorbing agent in the present invention include specific indolenine cyanine dyes described in Japanese Patent Application Nos. 2001-6326 and 2001-237840 supra.

The cyanine dyes represented by formula (a) is particularly preferably a dye which does not contain a halogen ion as a counter ion.

Examples of the pigment includes commercially available pigments and those described in the Color Index (C. I.) Handbook, Saishin Ganryo Binran (Latest Dye Handbook) (published in 1977 and compiled by the Japanese Society of Pigment Technology); Saishin Ganryho Oyo Gijyutsu (Latest Pigment Applied Technology) (published in 1986 by CMC Publishing Co., Ltd.); and Insatsu Inki Gijyutsu (Printing Ink Technology) (published in 1984 by CMC Publishing Co., Ltd.).

Examples of the pigment include black pigments, yellow pigments, orange pigments, brown pigments, red pigments, violet pigments, blue pigments, green pigments, fluorescent pigments, metallic powder pigments, and other pigments such as polymer-binding dyes. Specific examples of preferable pigments include insoluble azo pigments, azo lake pigments, condensed azo pigments, chelate azo pigments, phthalocyanine type pigments, anthraquinone type pigments, perylene and perinone type pigments, thioindigo type pigments, quinacridone type pigments, dioxazine type pigments, isoindolinone type pigments, quinophthalone type pigments, dyed lake pigments, azine pigments, nitroso pigments, nitro pigments, natural pigments, fluorescent pigments, inorganic pigments, and carbon black, which is preferable among these.

The pigments may or may not be subjected to surface treatment. Methods of surface treatment include coating the surface with resin or wax; allowing a surfactant to adhere to the surface; and bonding a reactive material (e.g., a silane coupling agent, an epoxy compound, a polyisocyanate, etc.) onto the surface of the pigment. These methods of surface treatment are described in Kinzoku Sekken No Seishitsu To Oyo (Properties and Application of Metallic Soap) (Sachi Shobo); Insatsu Inki Gijyutsu (Printing Ink Technology) (published in 1984 by CMC Publishing Co., Ltd.); and Saishin Ganryho Oyo Gijyutsu (Latest Pigment Applied Technology) (published in 1986 by CMC Publishing Co., Ltd.).

The particle diameters of the pigments are in the range of preferably 0.01 to 10 µm, more preferably 0.05 to 1 µm, most preferably 0.1 to 1 µm. When the particle diameters are in the preferable range, dispersion stability of the pigments in the coating solution and uniformity of the photosensitive layer can be achieved.

In the method of dispersing the pigment, known dispersing machines used widely in production of inks or toners and dispersing techniques can be suitably selected. Examples of suitable dispersing machines include a supersonic dispersing device, sand mill, attritor, pearl mill, super mill, ball mill, impeller, disperser, KD mill, colloid mill, dynatron, triple roll mill, press kneader, etc. These are described in detail in the aforementioned Saishin Ganryho Oyo Gijyutsu (Latest Newest Pigment Applied Technology) (published in 1986 by CMC Publishing Co., Ltd.).

The aforementioned infrared absorbing agents, along with other components, may be added to the same layer or to a separately provided layer in the photosensitive layer of the invention.

These infrared absorbing agents can be added in a ratio of 0.01 to 50% by mass, more preferably 0.1 to 10% by mass, and as the infrared absorbing agent, the dye can be added in the range of 0.5 to 10% by mass, and the pigment can be added in the range of 0.1 to 10% by mass, based on a total solid content in the photosensitive layer, from the viewpoint of uniformity and durability of the photosensitive layer.

### (Polymerization Initiator)

Any compound may be used as the polymerization initiator used in the invention insofar as it has the abilities to initiate and to progress a reaction for curing a polymerizable compound which will be explained later and generates radicals by supplying energy: examples of these compounds include thermally decomposable radical generators which are decomposed by heat to generate radicals, electron transfer type radical generators which receive excited electrons of an infrared absorber to generate radicals or electron transfer type radical generators whose electrons transfer to an excited infrared absorber to generate radicals. Examples of these compounds include onium salts, activated halogen compounds, oxime ester compounds and borate compounds. Two or more of these compounds may be used together. In the invention, onium salts are preferable and among the onium salts, sulfonium salts are particularly preferable.

The sulfonium salt polymerization initiator used preferably in the present invention includes onium salts represented by the following formula (1).

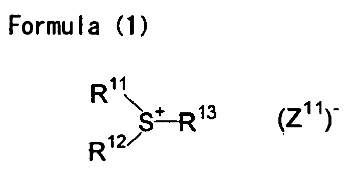

In the formula (1), R¹¹, R¹² and R¹³ each independently represent a hydrocarbon group having 20 or less carbon atoms, which may have a substituent group. The substituent group is preferably a halogen atom, a nitro group, an alkyl group having 12 or less carbon atoms, an alkoxy group having 12 or less carbon atoms, or an aryloxy group having 12 or less carbon atoms. (Z¹¹)⁻ represents a counter ion selected from the group consisting of a halogen ion, a perchlorate ion, a tetrafluoroborate ion, a hexafluorophosphate ion, a carboxylate ion and a sulfonate ion, preferably a perchlorate ion, a hexafluorophosphate ion, a carboxylate ion and an aryl sulfonate ion.

Hereinafter, examples of the onium salts ([OS-1] to [OS-12]) represented by the formula (1) are mentioned, but the onium salts are not limited thereto.

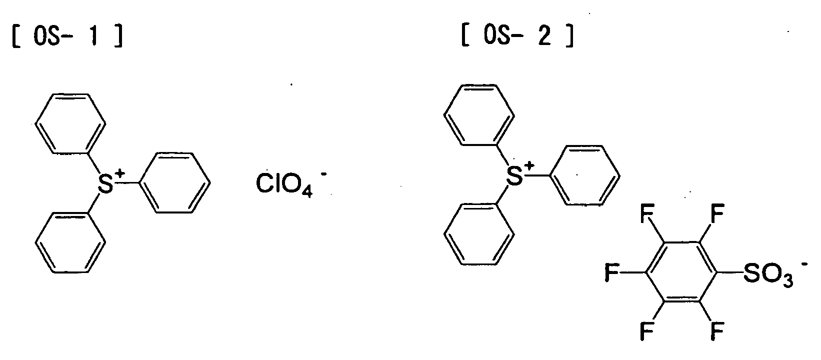

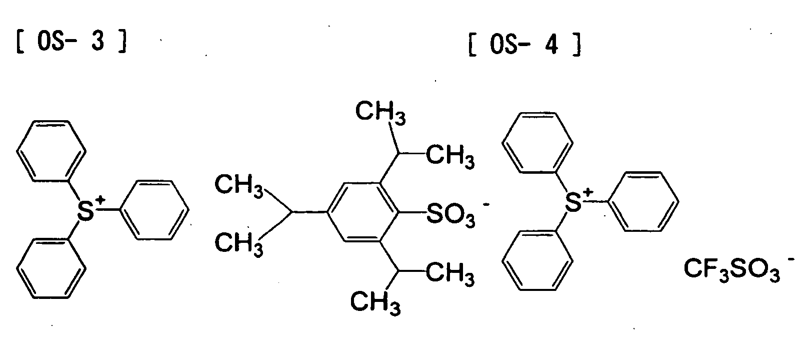

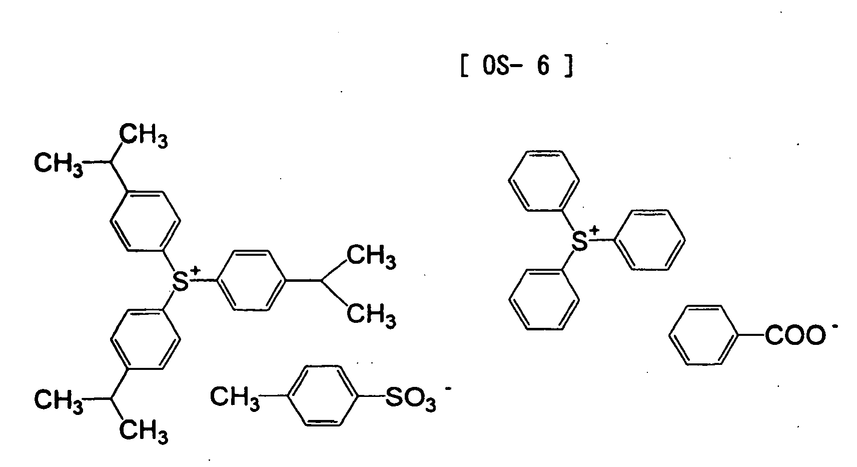

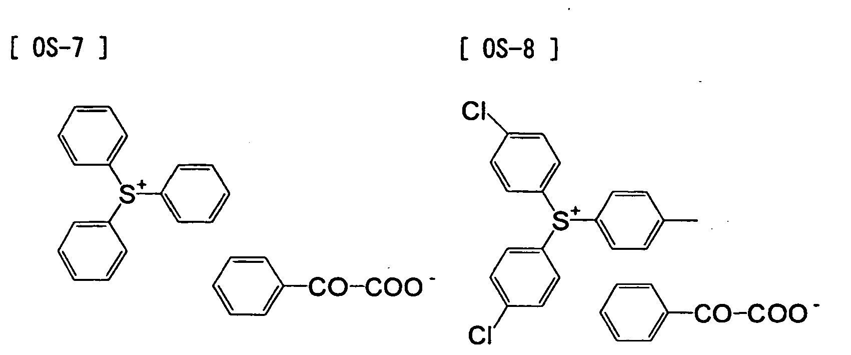

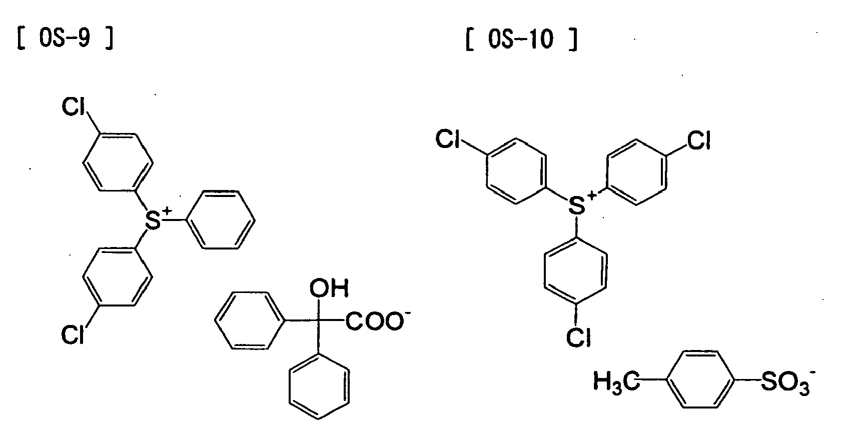

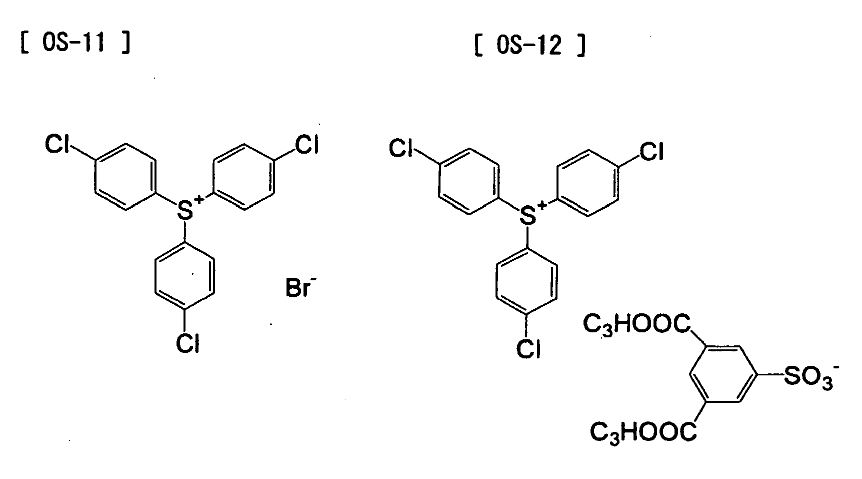

In addition to those described above, specific aromatic sulfonium salts described in JP-A Nos. 2002-148790, 2002-350207 and 2002-6482 can also be preferably used.

In the present invention, other polymerization initiators (other radical generating agents) can be used than the sulfonium salt polymerization initiator. The other radical generating agents include onium salts (excluding sulfonium salts), triazine compounds having a trihalomethyl group, peroxides, azo-type polymerization initiators, azide compounds, quinone diazide, activated halogen compounds, oxime ester compounds and triaryl monoalkyl borate compounds. Among these compounds, the onium salts are highly sensitive and preferably used. These polymerization initiators (radical generating agents) can be used in combination with the sulfonium salt polymerization initiator

Examples of the onium salts which can be used preferably in the present invention include iodonium salts and diazonium salts. In the present invention, these onium salts function not as acid generating agents but as radical polymerization initiators.

Examples of the onium salts used preferably in the present invention include onium salts represented by the formulae (2) and (3).

Formula (2) Ar²¹―I⁺―Ar²² (Z²¹)⁻

Formula (3) Ar³¹―N⁺≡N (Z³¹)⁻

In the formula (2), Ar²¹ and Ar²² each independently represent an aryl group having 20 or less carbon atoms, which may have a substituent group. When this aryl group has a substituent group, the substituent group is preferably a halogen atom, a nitro group, an alkyl group having 12 or less carbon atoms, an alkoxy group having 12 or less carbon atoms, or an aryloxy group having 12 or less carbon atoms. (Z²¹)⁻ represents a counter ion having the same meaning as defined for (Z¹¹)⁻.

In the formula (3), Ar³¹ represents an aryl group having 20 or less carbon atoms, which may have a substituent group. The substituent group is preferably a halogen atom, a nitro group, an alkyl group having 12 or less carbon atoms, an alkoxy group having 12 or less carbon atoms or an aryloxy group having 12 or less carbon atoms, an alkylamino group having 12 or less carbon atoms, a dialkylamino group having 12 carbon atoms, an arylamino group having 12 or less carbon atoms, or a diarylamino group having 12 or less carbon atoms. (Z³¹)⁻ represents a counter ion having the same meaning as defined for (Z¹¹)⁻.

Preferable examples of the iodonium salts ([OI-1] to [OI-10]) represented by the formula (2) and the diazonium salts ([ON-1] to [ON-5]) represented by the formula (3) are mentioned below, but the onium salts are not limited thereto.

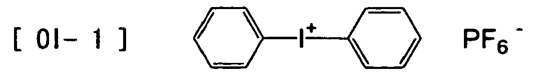

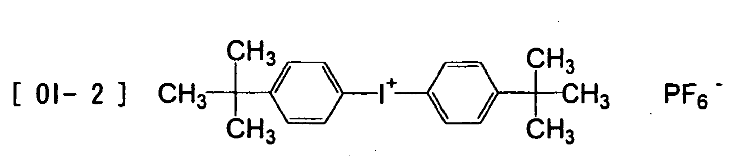

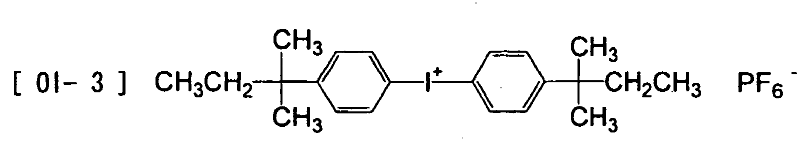

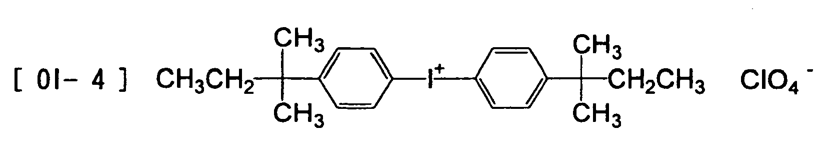

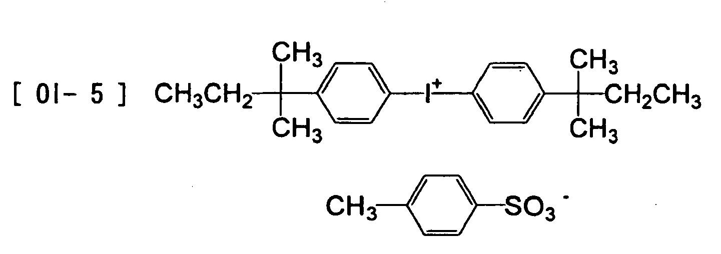

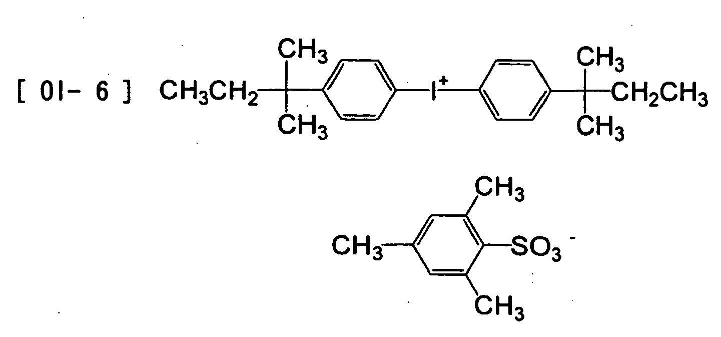

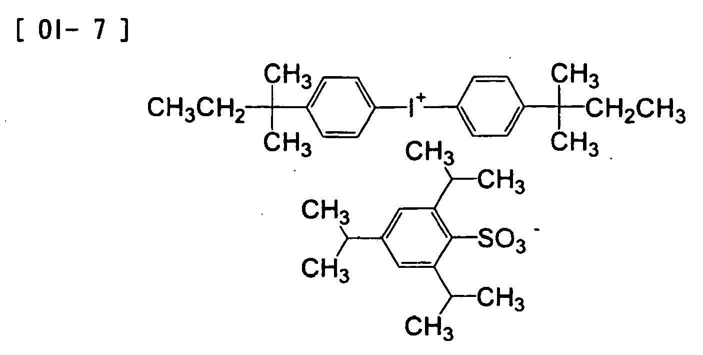

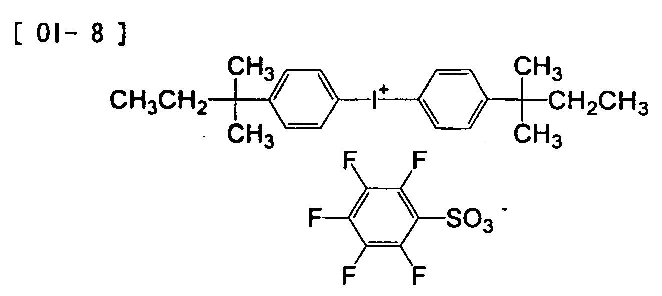

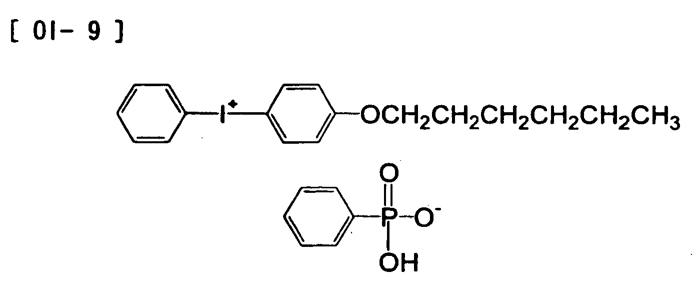

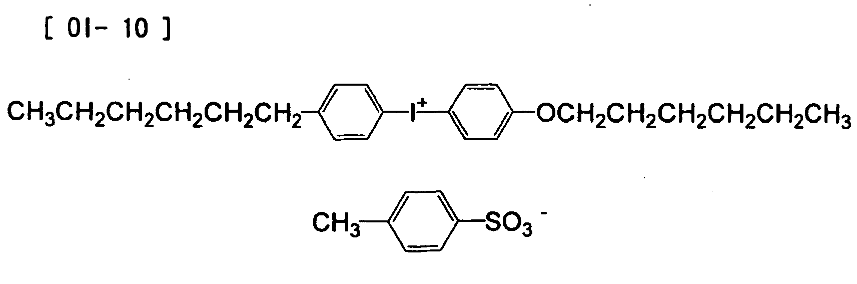

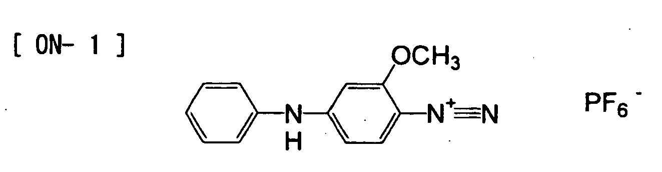

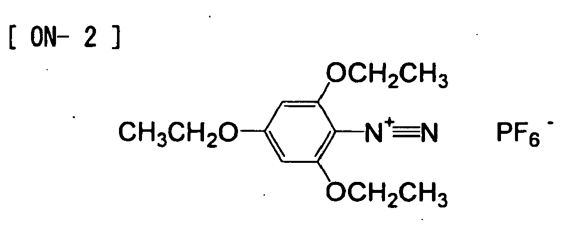

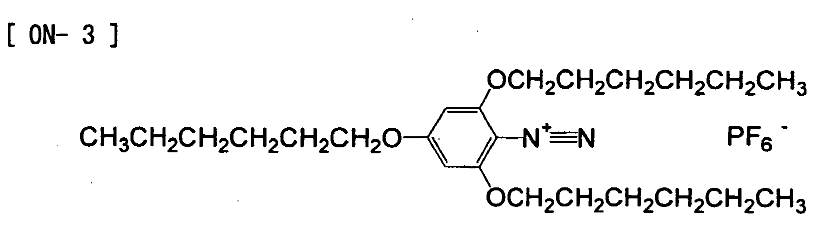

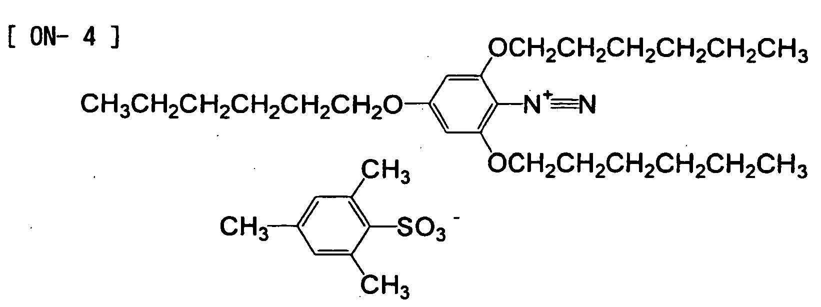

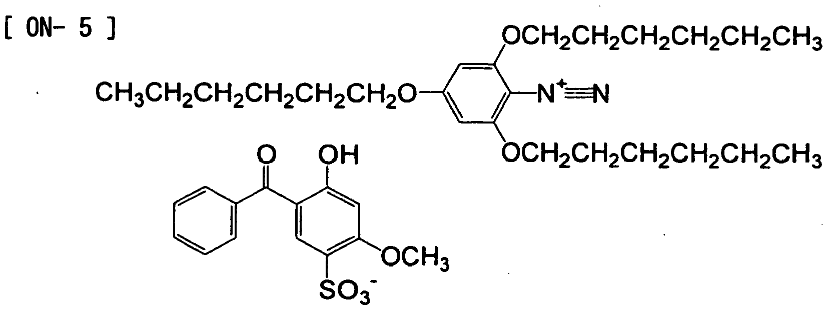

In the present invention, examples of the onium salts preferably used as the polymerization initiator (radical generating agent) include those described in JP-A No. 2001-133696.

The polymerization initiator (radical-generating agent) used in the present invention has a maximum absorption wavelength of preferably 400 nm or less, more preferably 360 nm or less. By using the radical-generating agent having its absorption wavelength in the UV range, the planographic printing plate precursor can be handled under an incandescent lamp.

From the viewpoint of sensitivity and the generation of smudging in a non-image at the time of printing, the total content of the polymerization initiator in the present invention is 0.1 to 50% by mass, and preferably 0.5 to 30% by mass, more preferably 1 to 20% by mass, based on a total solid content in the photosensitive layer.

In the present invention, only one polymerization initiator or two or more polymerization initiators may be used. When two or more polymerization initiators are used in combination, for example, two or more sulfonium salt polymerization initiators, which are preferably used, can be used, or the sulfonium salt polymerization initiator can be used in combination with another polymerization initiator.

When the sulfonium salt polymerization initiator is used in combination with other polymerization initiator, the ratio (ratio by mass) of the sulfonium salt polymerization initiator to the other polymerization initiator is preferably 100/1 to 100/50, more preferably 100/5 to 100/25.

The polymerization initiator, along with other components, may be added to the same layer or to a separately provided layer.

In the case of using a highly sensitive sulfonium salt polymerization initiator which is desirable as the polymerization initiator in the photosensitive layer in the invention, a radial polymerization reaction proceeds efficiently to make the formed image very strong. Accordingly, a planographic printing plate having an oxygen-cutoff function obtained by the high protective layer which will be explained later and also high strength of an image area can be manufactured, with the result that printing durability is more improved. Also, because the sulfonium salt polymerization initiator is itself superior in stability with time, there is the advantage that the generation of an undesired polymerization reaction is suppressed efficiently when the manufactured planographic printing plate precursor is stored.

### (Polymerizable compound)

The polymerizable compound used in the present invention is an addition-polymerizable compound having at least one ethylenically unsaturated double bond, and is selected from compounds each having at least one (preferably two or more) ethylenically unsaturated bond. A group of such compounds is known widely in this industrial field, and in the present invention these compounds can be used without any particular limitation. These compounds occur in chemical forms such as monomers, prepolymers, that is, dimers, trimers and oligomers, as well as mixtures thereof and copolymers thereof. Examples of such monomers and copolymers include unsaturated carboxylic acids (e.g., acrylic acid, methacrylic acid, itaconic acid, crotonic acid, isocrotonic acid, maleic acid etc.) and esters and amides thereof, and preferably used among these compounds are esters between unsaturated carboxylic acids and aliphatic polyvalent alcohol compounds and amides between unsaturated carboxylic acids and aliphatic polyvalent amine compounds. Also preferably used among these compounds are unsaturated carboxylates having nucleophilic substituent groups such as hydroxyl group, amino group, mercapto group etc., addition-reaction products of amides with monofunctional or multifunctional isocyanates or epoxy compounds, and dehydration condensation reaction products of amides with monofunctional or multifunctional carboxylic acids. Also preferably used among these compounds are unsaturated carboxylates having electrophilic substituent groups such as isocyanate group, epoxy group etc., addition-reaction products of amides with monofunctional or multifunctional alcohols, amines or thiols, unsaturated carboxylates having eliminating substituent groups such as halogen group, tosyloxy group etc., and substitution-reaction products of amides with monofunctional or multifunctional alcohols, amines or thiols. A group of those compounds wherein the above-described carboxylic acids have been replaced by unsaturated phosphonic acid, styrene, vinyl ethers etc., can also be used.

As the ester monomers between aliphatic polyvalent alcohols and unsaturated carboxylic acids, the acrylates include ethylene glycol diacrylate, triethylene glycol diacrylate, 1,3-butane diol diacrylate, tetramethylene glycol diacrylate, propylene glycol diacrylate, neopentyl glycol diacrylate, trimethylol propane triacrylate, trimethylol propane tri(acryloyloxypropyl)ether, trimethylol ethane triacrylate, hexane diol diacrylate, 1,4-cyclohexane diol diacrylate, tetraethylene glycol diacrylate, pentaerythritol diacrylate, pentaerythritol triacrylate, pentaerythritol tetracrylate, dipentaerythritol diacrylate, dipentaerythritol hexacrylate, sorbitol triacrylate, sorbitol tetracrylate, sorbitol pentacrylate, sorbitol hexacrylate, tri(acryloyloxyethyl) isocyanurate, polyester acrylate oligomers etc.

The methacrylates include tetramethylene glycol dimethacrylate, triethylene glycol dimethacrylate, neopentyl glycol dimethacrylate, trimethylol propane trimethacrylate, trimethylol ethane trimethacrylate, ethylene glycol dimethacrylate, 1,3-butane diol dimethacrylate, hexane diol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)phenyl]dimethyl methane, bis[p-(methacryloxyethoxy)phenyl]dimethyl methane etc.

The itaconates include ethylene glycol diitaconate, propylene glycol diitaconate, 1,3-butane diol diitaconate, 1,4-butane diol diitaconate, tetramethylene glycol diitaconate, pentaerythritol diitaconate, sorbitol tetraitaconate etc.

The crotonates include ethylene glycol dicrotonate, tetramethylene glycol dicrotonate, pentaerythritol dicrotonate, sorbitol tetradicrotonate etc.

The isocrotonates include ethylene glycol diisocrotonate, pentaerythritol diisocrotonate, sorbitol tetraisocrotonate etc.

The maleates include ethylene glycol dimaleate, triethylene glycol dimaleate, pentaerythritol dimaleate, sorbitol tetramaleate etc.

Other preferably used esters include, for example, aliphatic alcohol-based esters described in Japanese Patent Application Publication (JP-B) Nos. 46-27926, 51-47334 and Japanese Patent Application Laid-Open (JP-A) No. 57-196231, those having an aromatic skeleton described in JP-A Nos. 59-5240, 59-5241 and 2-226149, and those having an amino group described in JP-A No. 1-165613. The ester monomers can also be used as a mixture.

The amide monomers between aliphatic polyvalent amine compounds and unsaturated carboxylic acids include, for example, methylene bis-acrylamide, methylene bis-methacrylamide, 1,6-hexamethylene bis-acrylamide, 1,6-hexamethylene bis-methacrylamide, diethylene triamine trisacrylamide, xylylene bisacrylamide, xylylene bismethacrylamide etc. Preferable examples of other amide type monomers include those having a cyclohexylene structure described in JP-B No. 54-21726.

Urethane type addition-polymerizable compounds produced by addition reaction between isocyanates and hydroxyl groups are also preferable, and examples thereof includes vinyl urethane compounds containing two or more polymerizable vinyl groups in one molecule, which are prepared by adding vinyl monomers containing a hydroxyl group shown in the formula below to polyisocyanates compound having two or more isocyanate groups in one molecule as described in JP-B No. 48-41708.

Formula CH₂=C(R^{a})COOCH₂CH(R^{b})OH

In the Formula, R^{a} and R^{b} each independently represent H or CH₃.

Urethane acrylates described in JP-A No. 51-37193, JP-B Nos. 2-32293 and 2-16765 and urethane compounds having an ethylene oxide-type skeleton described in JP-B Nos. 58-49860, 56-17654, 62-39417 and 62-39418 are also preferable. Addition-polymerizable compounds having an amino structure or sulfide structure in the molecule as described in JP-ANos. 63-277653, 63-260909 and 1-105238 can be used to prepare photopolymerizable compositions extremely excellent in photosensitizing speed.

As other examples, multifunctional acrylates and methacrylates such as polyacrylates and epoxy acrylates obtained by reacting epoxy resin with (meth)acrylic acid as described in JP-A No. 48-64183, JP-B Nos. 49-43191 and 52-30490 can be mentioned. Specific unsaturated compounds described in JP-B Nos. 46-43946, 1-40337 and 1-40336 and vinyl phosphonic acid-type compounds described in JP-A No. 2-25493 can also be mentioned. In some cases, a structure containing a perfluoroalkyl group described in JP-A No. 61-22048 is preferably used. Photo-curable monomers and oligomers described in the Journal of Japanese Adhesive Society, vol. 20, No. 7, pp.300-308 (1984) can also be used.

Details of method of using these addition-polymerizable compounds, for example, the structure thereof, single use or use in combination thereof, and the amount to be used, can be arbitrarily determined depending on the final performance and design of the material. For example, they are selected from the following viewpoints. From the viewpoint of photosensitizing speed, the additional-polymerizable compounds preferably have many unsaturated groups in one molecule, and in many cases, they are preferably bifunctional or more. In order to increase the strength of image areas, i.e. the cured layer, they are preferably trifunctional or more. It is also effective to use a method of regulating both photosensitivity and strength by combined use of compounds (e.g. acrylates, methacrylates, styrene type compounds, and vinyl ether type compounds) having different functionalities and different polymerizable groups. The high-molecular compounds or highly hydrophobic compounds, though being excellent in photosensitizing speed and film strength, may be undesirable in some cases in respect of developing speed and precipitation in the developing solution. The method of selecting and using the addition-polymerizable compound is an important factor for compatibility and dispersibility with other components (e.g. a binder polymer, an initiator, a colorant etc.) in the photosensitive layer composition, and the compatibility may be improved by using e.g. a low-purity compound or a combination of two or more compounds. In a planographic printing plate precursor of the invention, a specific structure can be selected for the purpose of improving adhesiveness to a support, a protective layer, described later, etc.

As to the content of the addition polymerizable compound in the photosensitive layer composition, the addition polymerizable compound is preferably used in an amount of 5 to 80% by mass and more preferably 40 to 75% by mass based on a total solid content in the photosensitive layer composition from the viewpoint of sensitivity, generation of phase separation, adhesion of the photosensitive layer and also precipitation characteristics from a developing solution.
These compounds may be used singly or in combination thereof. From the viewpoints of the degree of inhibition of polymerization by oxygen, resolution, fogging, a change in reflectance and surface adhesion, a suitable structure, compounding and amount thereof can be arbitrarily selected in the method of using the addition-polymerizable compound. In a planographic printing plate precursor of the invention, a layer structure and a coating method such as undercoating and overcoating can also be used as necessary.

### (Binder polymer)

From the viewpoint of improving layer-forming properties, the photosensitive layer in the present invention preferably comprises a binder polymer, particularly preferably a binder polymer having a repeating unit represented by the formula (i).
The binder polymer having a repeating unit represented by the formula (i) is also referred to as "specific binder polymer" and described in more detail below.

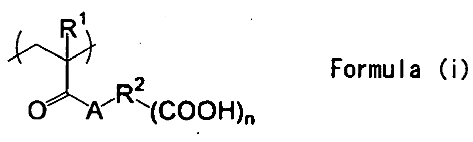

In the formula (i), R¹ represents a hydrogen atom or a methyl group; R² represents a linking group containing two or more atoms selected from the group consisting of a carbon atom, a hydrogen atom, an oxygen atom, a nitrogen atom and a sulfur atom, and the total number of atoms in R² is 2 to 82; A represents an oxygen atom or -NR³- in which R³ represents a hydrogen atom or a monovalent hydrocarbon group having 1 to 10 carbon atoms; and n is an integer from 1 to 5.

R¹ in the formula (i) represents a hydrogen atom or a methyl group, preferably a methyl group.

The linking group represented by R² in the formula (i) is a linking group containing two or more atoms selected from the group consisting of a carbon atom, a hydrogen atom, an oxygen atom, a nitrogen atom and a sulfur atom, and the total number of atoms in R² is 2 to 82, preferably 2 to 50, and more preferably 2 to 30. The total number of atoms refers to the number of atoms including atoms in a substituent group, if any, on the linking group. Specifically, the number of carbon atoms in the main skeleton of the linking group represented by R² is preferably 1 to 30, more preferably 3 to 25, still more preferably 4 to 20, and most preferably 5 to 10. The "main skeleton of the linking group" in the present invention refers to an atom or an atomic group used in linking A to the terminal COOH in the formula (i), and when a plurality of linkages are present, the main skeleton refers to an atom or an atomic group constituting a linkage having the smallest number of atoms. Accordingly, when the linking group has a cyclic structure, its linking sites (for example, o-, m-, p-, etc.) are different in the number of atoms to be introduced into them.

Specific examples of the linking group represented by R² include an alkylene group, a substituted alkylene group, an arylene group and a substituted arylene group, and these divalent groups may be in a chain structure bound to one another via amide or ester linkages.

Linking groups in the chain structure include ethylene, propylene, etc. A structure comprising these alkylene groups bound to one another via ester linkages is also preferable.

The linking group represented by R² in formula (i) is preferably a (n+1)-valent hydrocarbon group having an alicyclic structure having 3 to 30 carbon atoms. Examples thereof include (n+1)-valent hydrocarbon groups obtained by removing (n+1) hydrogen atoms on arbitrary carbon atoms constituting compounds having an alicyclic structure, such as cyclopropane, cyclopentane, cyclohexane, cycloheptane, cyclooctane, cyclodecane, dicyclohexyl, tertiary cyclohexyl and norbornane which may be substituted with one or more arbitrary substituent groups. R² is preferably the one containing 3 to 30 carbon atoms including carbon atoms in a substituent group if any.

The arbitrary carbon atoms in a compound constituting an alicyclic structure may be substituted with one or more heteroatoms selected from the group consisting of a nitrogen atom, an oxygen atom and a sulfur atom. In terms of printing durability, R² is preferably a (n+1)-valent hydrocarbon group having an alicyclic structure which may have a substituent group having 5 to 30 carbon atoms comprising two or more rings, such as a condensed polycyclic aliphatic hydrocarbon, a crosslinked alicyclic hydrocarbon, spiroaliphatic hydrocarbon, and combined aliphatic hydrocarbon rings (plural rings combined directly or via linking groups). The number of carbon atoms refers to the number of carbon atoms including carbon atoms in a substituent group, if any.

The linking group represented by R² is preferably a group containing 5 to 10 atoms constituting a main structure of the linking group, having a cyclic structure containing an ester linkage or the cyclic structure described above.

A substituent group which can be introduced into the linking group represented by R² includes a monovalent non-metal atomic group excluding hydrogen, and examples thereof include a halogen atom (-F, -Br, -Cl, -I), hydroxyl group, alkoxy group, aryloxy group, mercapto group, alkyl thio group, aryl thio group, alkyl dithio group, aryl dithio group, amino group, N-alkyl amino group, N,N-dialkyl amino group, N-aryl amino group, N,N-diaryl amino group, N-alkyl-N-aryl amino group, acyloxy group, carbamoyloxy group, N-alkylcarbamoyloxy group, N-aryl carbamoyloxy group, N,N-dialkyl carbamoyloxy group, N,N-diaryl carbamoyloxy group, N-alkyl-N-aryl carbamoyloxy group, alkyl sulfoxy group, aryl sulfoxy group, acyl thio group, acyl amino group, N-alkyl acyl amino group, N-aryl acyl amino group, ureido group, N'-alkyl ureido group, N',N'-dialkyl ureido group, N'-aryl ureido group, N',N'-diaryl ureido group, N'-alkyl-N'-aryl ureido group, N-alkyl ureido group, N-aryl ureido group, N'-alkyl-N-alkyl ureido group, N'-alkyl-N-aryl ureido group, N',N'-dialkyl-N-alkyl ureido group, N',N'-dialkyl-N-aryl ureido group, N'-aryl-N-alkyl ureido group, N'-aryl-N-aryl ureido group, N',N'-diaryl-N-alkyl ureido group, N',N'-diaryl-N-aryl ureido group, N'-alkyl-N'-aryl-N-alkyl ureido group, N'-alkyl-N'-aryl-N-aryl ureido group, alkoxy carbonyl amino group, aryloxy carbonyl amino group, N-alkyl-N-alkoxycarbonyl amino group, N-alkyl-N-aryloxy carbonyl amino group, N-aryl-N-alkoxycarbonyl amino group, N-aryl-N-aryloxycarbonyl amino group, formyl group, acyl group, carboxyl group and its conjugated basic group, alkoxy carbonyl group, aryloxy carbonyl group, carbamoyl group, N-alkyl carbamoyl group, N,N-dialkyl carbamoyl group, N-aryl carbamoyl group, N,N-diaryl carbamoyl group, N-alkyl-N-aryl carbamoyl group, alkyl sulfinyl group, aryl sulfinyl group, alkyl sulfonyl group, aryl sulfonyl group, sulfo group (-SO₃H) and its conjugated basic group, alkoxy sulfonyl group, aryloxy sulfonyl group, sulfinamoyl group, N-alkyl sulfinamoyl group, N,N-dialkyl sulfinamoyl group, N-aryl sulfinamoyl group, N,N-diaryl sulfinamoyl group, N-alkyl-N-aryl sulfinamoyl group, sulfamoyl group, N-alkyl sulfamoyl group, N,N-dialkyl sulfamoyl group, N-aryl sulfamoyl group, N,N-diaryl sulfamoyl group, N-alkyl-N-aryl sulfamoyl group, N-acyl sulfamoyl group and its conjugated basic group, N-alkyl sulfonyl sulfamoyl group (-SO₂NHSO₂ (alkyl)) and its conjugated basic group, N-aryl sulfonyl sulfamoyl group (-SO₂NHSO₂(aryl)) and its conjugated basic group, N-alkyl sulfonyl carbamoyl group (-CONHSO₂(alkyl)) and its conjugated basic group, N-aryl sulfonyl carbamoyl group (-CONHSO₂(aryl)) and its conjugated basic group, alkoxy silyl group (-Si(O-alkyl)₃), aryloxy silyl group (-Si(O-aryl)₃), hydroxylyl group (-Si(OH)₃) and its conjugated basic group, pohsphono group (-PO₃H₂) and its conjugated basic group, dialkyl phosphono group (-PO₃(alkyl)₂), diaryl phosphono group (-PO₃(aryl)₂), alkyl aryl phosphono group (-PO₃(alkyl)(aryl)), monoalkyl phosphono group (-PO₃H(alkyl)) and its conjugated basic group, monoaryl phosphono group (-PO₃H(aryl)) and its conjugated basic group, phosphonoxy group (-OPO₃H₂) and its conjugated basic group, dialkyl phosphonoxy group (-OPO₃(alkyl)₂), diaryl phosphonoxy group (-OPO₃(aryl)₂), alkyl aryl phosphonoxy group (-OPO₃(alkyl)(aryl)), monoalkyl phosphonoxy group (-OPO₃H(alkyl)) and its conjugated basic group, monoaryl phosphonoxy group (-OPO₃H(aryl)) and its conjugated basic group, cyano group, nitro group, dialkyl boryl group (-B(alkyl)₂), diaryl boryl group (-B(aryl)₂), alkyl aryl boryl group (-B(alkyl)(aryl)), dihydroxy boryl group (-B(OH)₂) and its conjugated basic group, alkyl hydroxy boryl group (-B(alkyl)(OH)) and its conjugated basic group, aryl hydroxy boryl group (-B(aryl)(OH)) and its conjugated basic group, aryl group, alkenyl group and alkynyl group.

In the planographic printing plate precursor of the present invention, although it depends on the design of the photosensitive layer, a substituent group having a hydrogen atom capable of hydrogen bonding, particularly a substituent group having acidity whose acid dissociation constant (pKa) is lower than that of carboxylic acid, is not preferable because it tends to deteriorate printing durability. On the other hand, a hydrophobic substituent group such as a halogen atom, a hydrocarbon group (alkyl group, aryl group, alkenyl group, alkynyl group), an alkoxy group and an aryloxy group is preferable because it tends to improve printing durability, and particularly when the cyclic structure is a 6- or less memberred monocyclic aliphatic hydrocarbon such as cyclopentane or cyclohexane, the hydrocarbon preferably has such hydrophobic substituent groups. If possible, these substituent groups may be bound to one another or to a substituted hydrocarbon group to form a ring, and the substituent groups may further be substituted.

When A in formula (i) is NR³-, R³ represents a hydrogen atom or a monovalent hydrocarbon group having 1 to 10 carbon atoms. The monovalent hydrocarbon group having 1 to 10 carbon atoms represented by R³ includes an alkyl group, aryl group, alkenyl group and alkynyl group.

Examples of the alkyl group include a linear, branched or cyclic alkyl group having 1 to 10 carbon atoms such as a methyl group, ethyl group, propyl group, butyl group, pentyl group, hexyl group, heptyl group, octyl group, nonyl group, decyl group, isopropyl group, isobutyl group, sec-butyl group, tert-butyl group, isopentyl group, neopentyl group, 1-methylbutyl group, isohexyl group, 2-ethylhexyl group, 2-methylhexyl group, cyclopentyl group, cyclohexyl group, 1-adamanthyl group and 2-norbomyl group.

Examples of the aryl group include an aryl group having 6 to 10 carbon atoms such as a phenyl group, naphthyl group and indenyl group, and a heteroaryl group having 5 to 10 carbon atoms containing one heteroatom selected from the group consisting of a nitrogen atom, an oxygen atom and a sulfur atom, for example a furyl group, thienyl group, pyrrolyl group, pyridyl group and quinolyl group.

Examples of the alkenyl group include a linear, branched or cyclic alkenyl group having 2 to 10 carbon atoms such as a vinyl group, 1-propenyl group, 1-butenyl group, 1-methyl-1-propenyl group, 1-cyclopentenyl group and 1-cyclohexenyl group.

Examples of the alkynyl group include an alkynyl group having 2 to 10 carbon atoms such as an ethynyl group, 1-propynyl group, 1-butynyl group and 1-octynyl group. Substituent groups which may be possessed by R³ include the same substituent groups as those capable of being introduced into R². The number of carbon atoms in R³, including the number of carbon atoms in its substituent group, is 1 to 10.

A in the formula (i) is preferably an oxygen atom or ―NH― because of easy synthesis.

n in the formula (i) is an integer from 1 to 5, preferably 1 in view of printing durability.

Preferable examples of the repeating unit represented by the formula (i) in the specific binder polymer are shown below, but the present invention is not limited thereto.

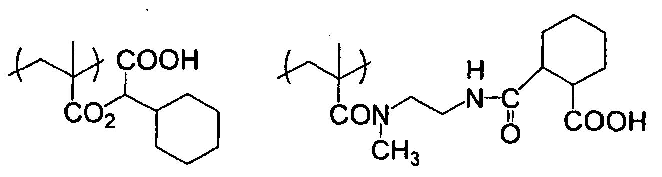

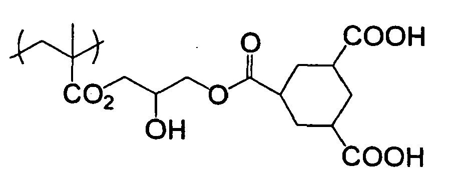

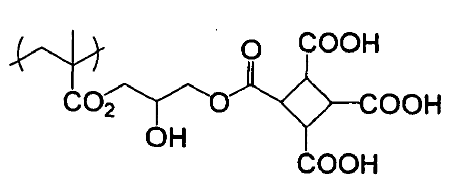

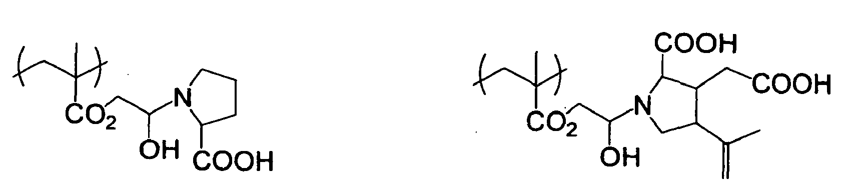

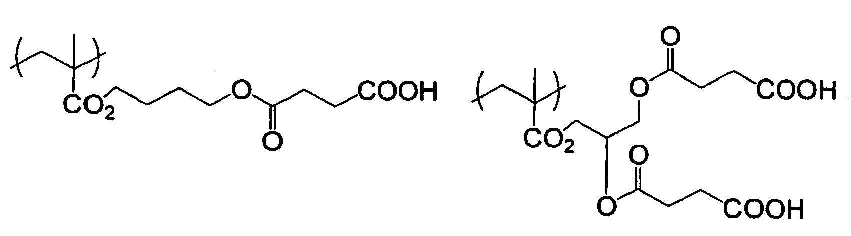

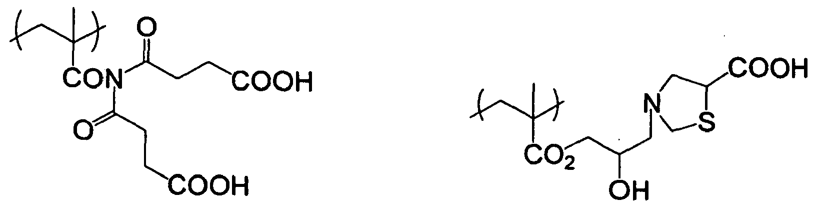

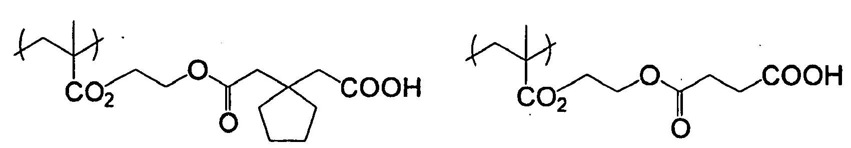

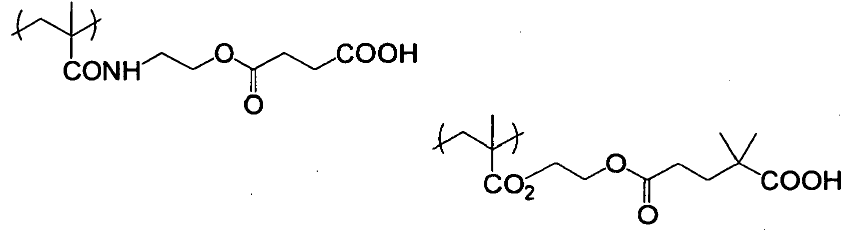

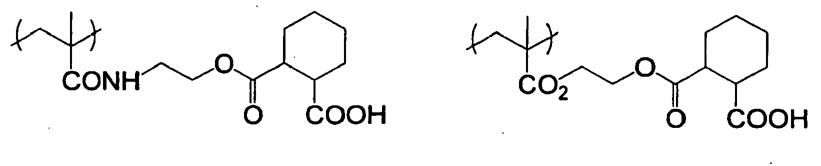

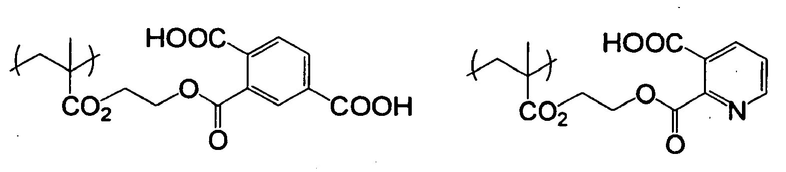

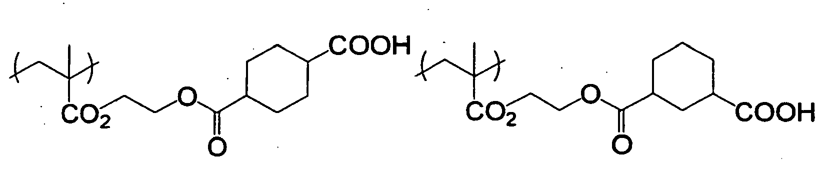

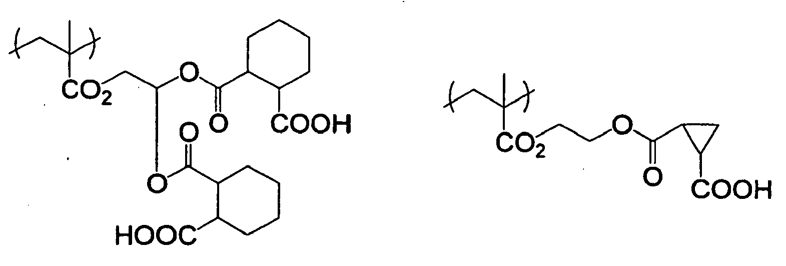

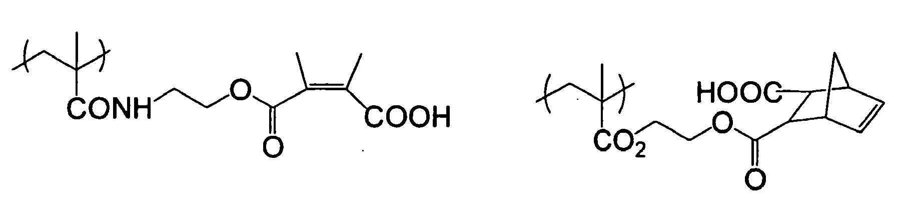

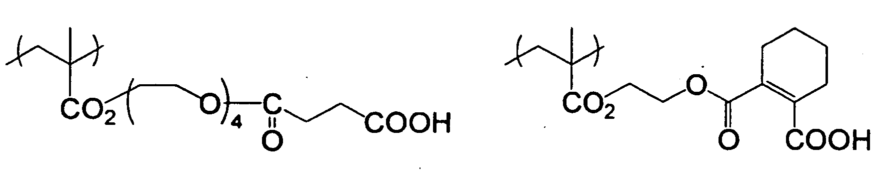

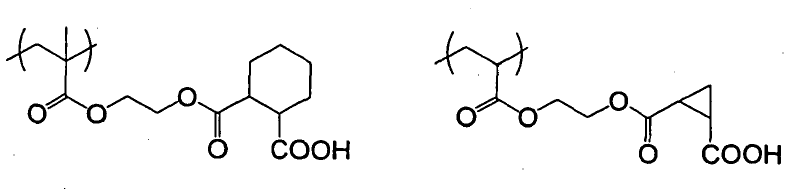

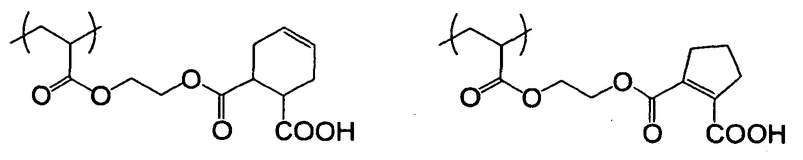

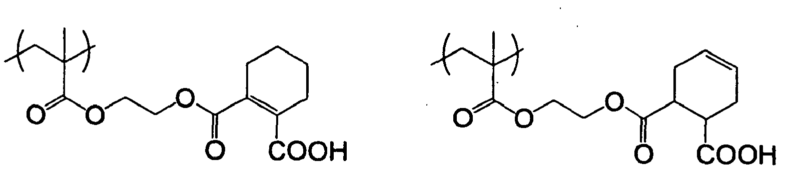

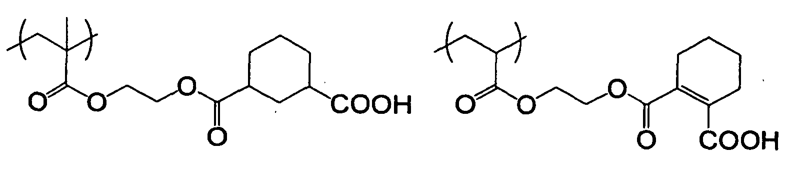

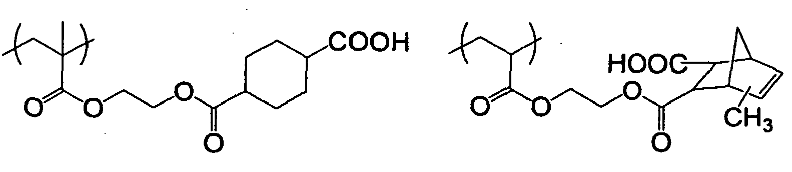

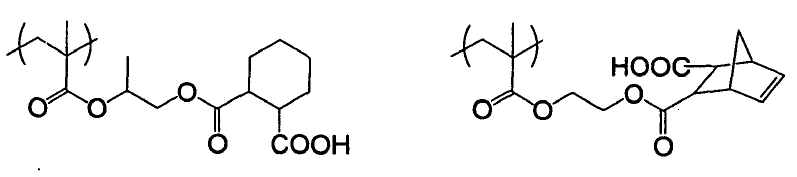

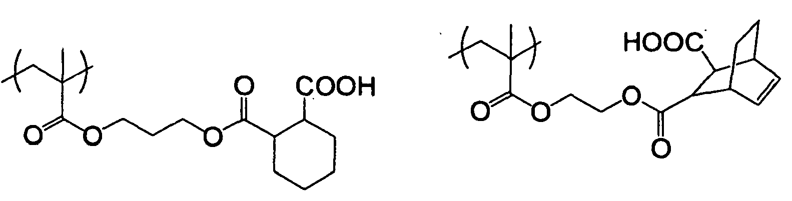

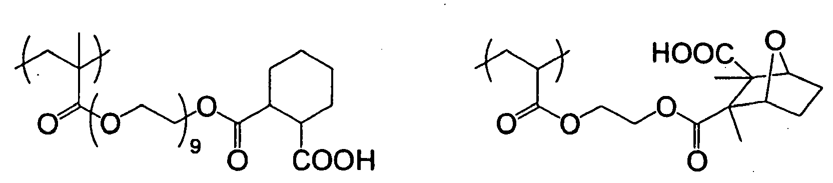

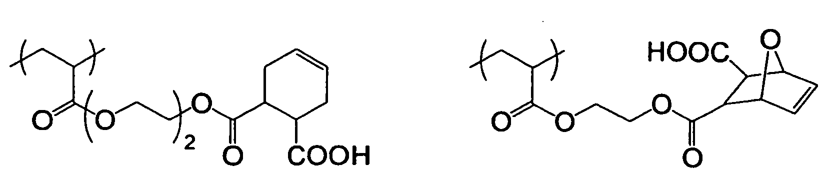

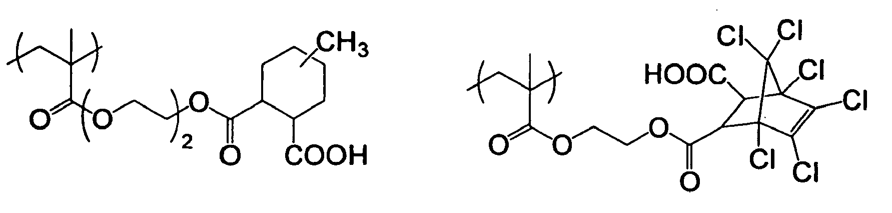

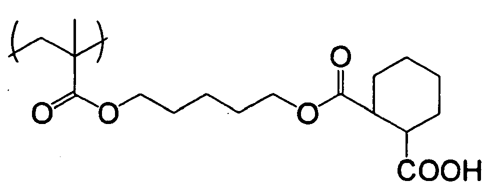

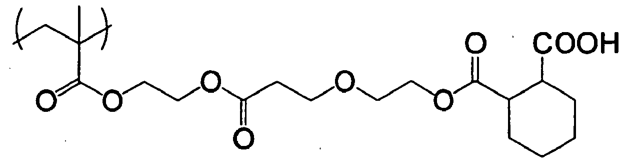

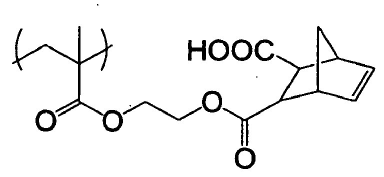

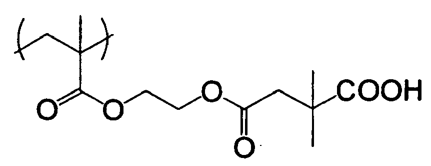

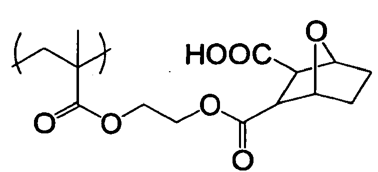

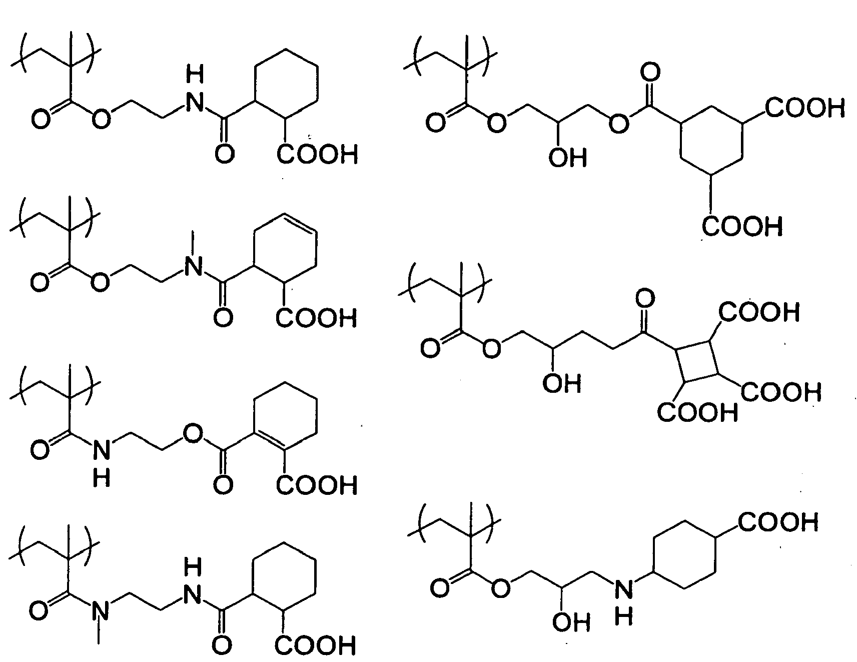

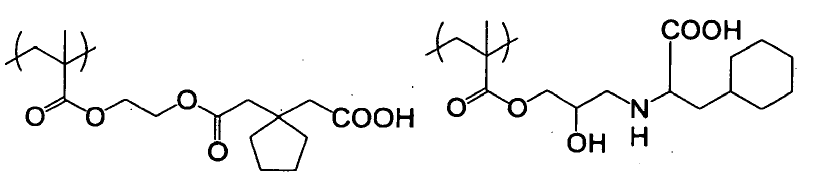

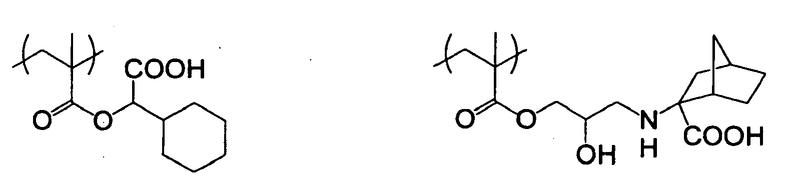

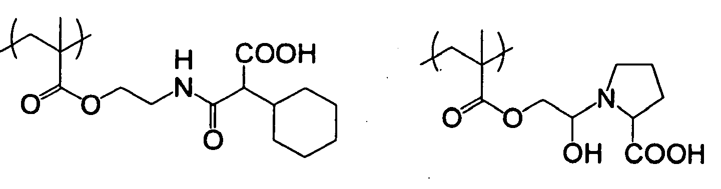

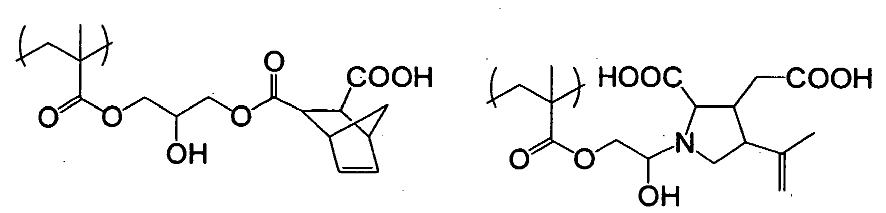

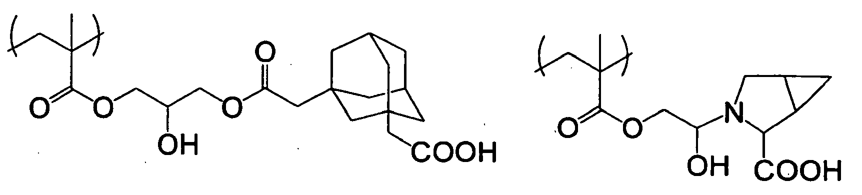

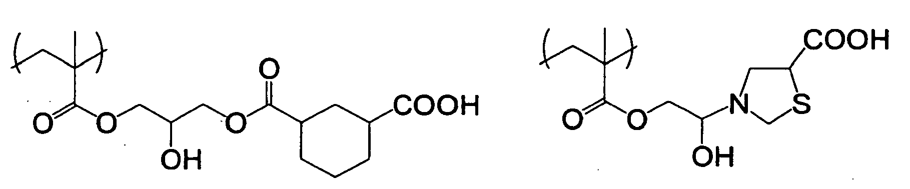

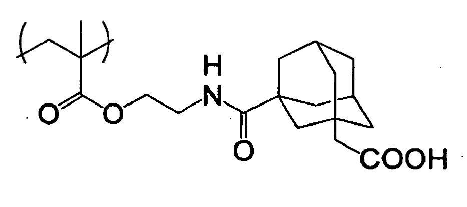

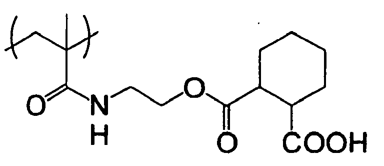

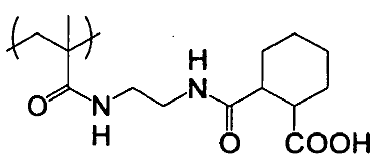

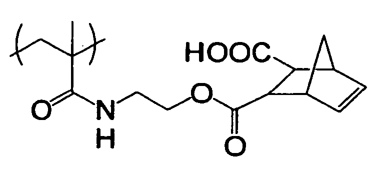

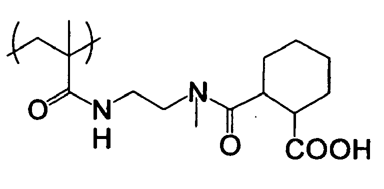

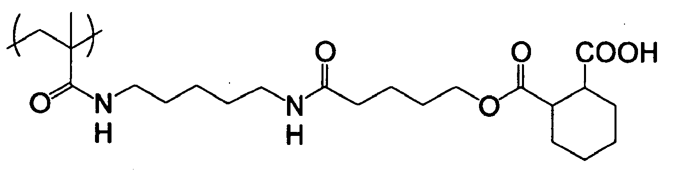

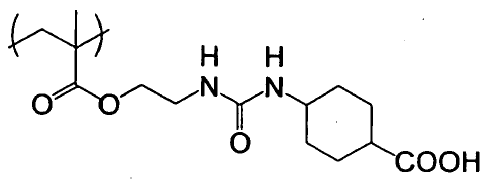

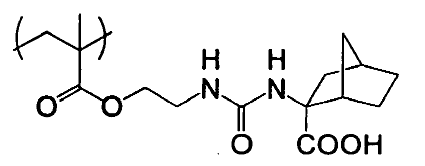

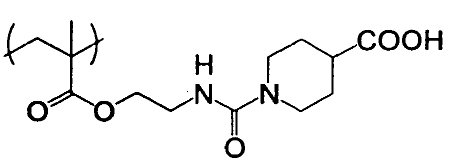

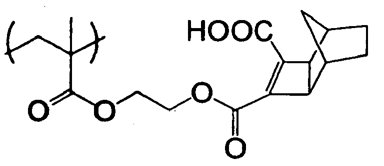

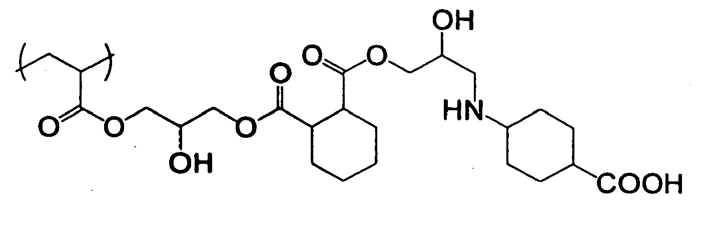

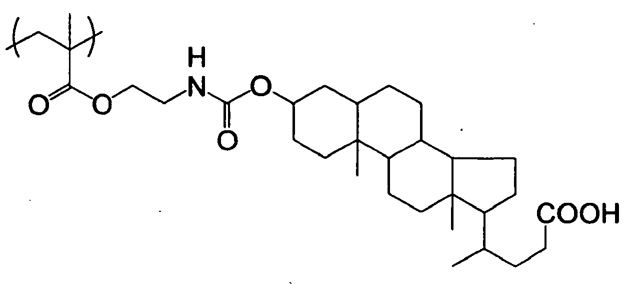

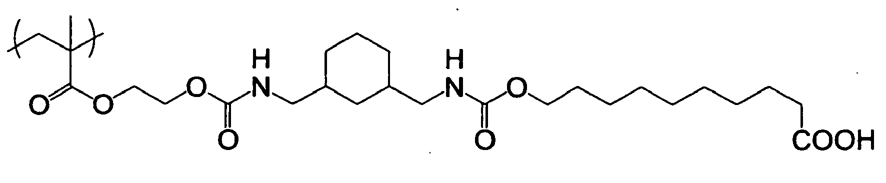

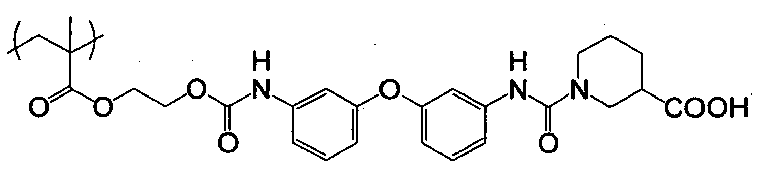

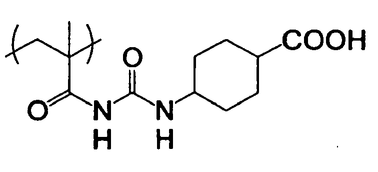

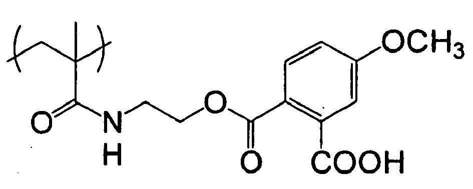

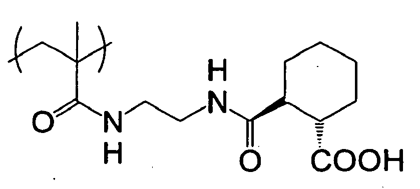

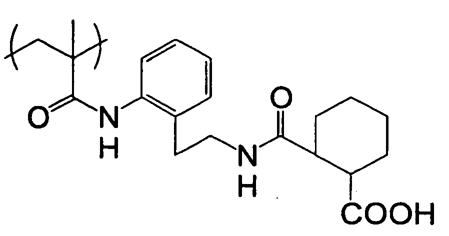

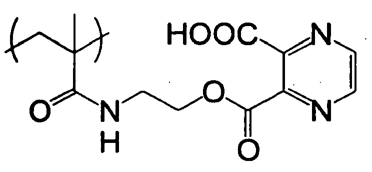

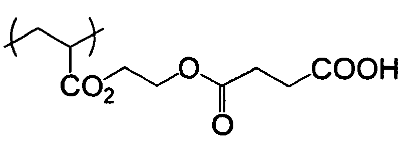

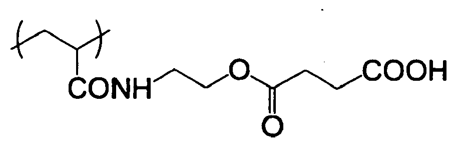

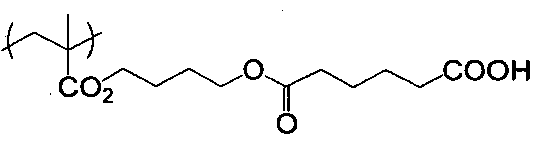

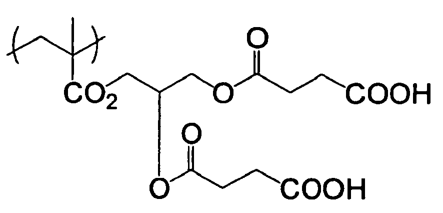

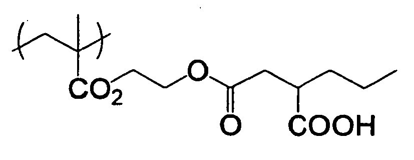

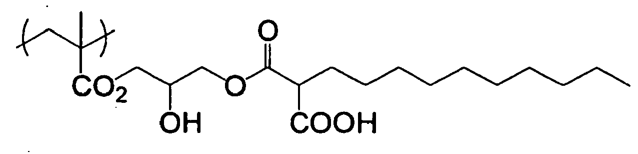

One or two or more kinds of repeating unit represented by the formula (i) may be contained in the binder polymer. The specific binder polymer in the present invention may be a polymer composed exclusively of the repeating unit represented by the formula (i), but is usually used as a copolymer containing other copolymerizable components. The total content of the repeating unit represented by the formula (i) in the copolymer is suitably determined depending on the structure of the copolymer, design of the photosensitive layer, etc., but usually the repeating unit represented by the formula (i) is contained in an amount of 1 to 99% by mole, more preferably 5 to 40% by mole, and still more preferably 5 to 20% by mole, based on the total molar amount of the polymer components.

When a copolymer is used as the binder polymer, copolymerizable components known in the art can be used without limitation insofar as they are radical-polymerizable monomers. Specifically, monomers described in the Polymer Data Handbook-Fundamental Version- compiled by the Society of Polymer Science, Japan and published by Baifukan, 1986 are exemplified. Such copolymerizable components can be used alone or in combination.

The molecular weight of the specific binder polymer in the present invention is suitably determined from the viewpoint of image-forming property and printing durability. The molecular weight is preferably in the range of 2,000 to 1,000,000, more preferably 5,000 to 500,000, and still more preferably 10,000 to 200,000.

As the binder polymer used in the photosensitive layer in the present invention, the specific binder polymer may be used alone, or may be used in combination with one or more other binder polymers. When the specific binder is used, binder polymers used in combination therewith are used in the range of 1 to 60% by mass, preferably 1 to 40% by mass, and more preferably 1 to 20% by mass, based on the total weight of the binder polymer components. As the binder polymer, any known binder polymers can be used without limitation, and specifically an acrylic main-chain binder and an urethane binder used often in this field are preferably used.

The total amount of the specific binder polymer and binder polymers which can be used in combination therewith in the photosensitive layer composition can be suitably determined, and is usually 10 to 90% by mass, preferably 20 to 80% by mass, and more preferably 30 to 70% by mass, based on the total mass of nonvolatile components in the photosensitive composition.

The acid value (meg/g) of the binder polymer is preferably in the range of 2.00 to 3.60.

### - Other binder polymers usable in combination -

The binder polymer which can be used in combination with the specific binder polymer is preferably a binder polymer having a radical-polymerizable group. The radical-polymerizable group is not particularly limited insofar as it can be polymerized with a radical, and examples thereof include α-substituted methyl acryl group [-OC(=O)-C(-CH₂Z)=CH₂ wherein Z is a hydrocarbon group starting from a heteroatom], acryl group, methacryl group, allyl group and styryl group, among which an acryl group and methacryl group are preferable.

The content of the radical-polymerizable group in the binder polymer (content of radical-polymerizable unsaturated double bonds determined by iodine titration) is preferably 0.1 to 10.0 mmol, more preferably 1.0 to 7.0 mmol, and most preferably 2.0 to 5.5 mmol, per 1 g of the binder polymer from the viewpoint of sensitivity and storability.

Preferably, the binder polymer further has an alkali-soluble group. The content of the alkali-soluble group (acid value determined by neutralization titration) in the binder polymer is preferably 0.1 to 3.0 mmol, more preferably 0.2 to 2.0 mmol, and most preferably 0.45 to 1.0 mmol, per 1 g of the binder polymer, from the viewpoint of precipitation of development scum and printing durability.

The weight-average molecular weight of the binder polymer is in the range of preferably 2,000 to 1,000,000, more preferably 10,000 to 300,000, and most preferably 20,000 to 200,000, from the viewpoint of film property (printing durability) and solubility in a coating solvent.

The glass transition point (Tg) of the binder polymer is in the range of preferably 70° to 300°C, more preferably 80° to 250°C, and most preferably 90° to 200°C, from the viewpoint of storage stability, printing durability and sensitivity.

As a means of increasing the glass transition point of the binder polymer, its molecule preferably contains an amide group or imide group, and particularly preferably contains methacrylamide derivatives.

### (Other component)

In addition to the fundamental components described above, other components suitable for uses, process, etc., can be added to the photosensitive composition of the present invention. Hereinafter, preferable additives are mentioned.

### - Colorant -

Dyes or pigments may be added to the photosensitive layer of the present invention for the purpose of coloring. The plate-checking property, that is, the visibility of the printing plate after plate-making and the applicability for image densitometer can thereby be improved when the composition is applied to the printing plate. Examples of the colorant include pigments such as phthalocyanine type pigments, azo type pigments, carbon black and titanium oxide, and dyes such as ethyl violet, crystal violet, azo type dyes, anthraquinone type dyes and cyanine type dyes. Among these colorants, cationic dyes are preferable.
The amount of the dyes and pigments added is preferably about 0.5 to about 5% by mass of nonvolatile components in the entire photosensitive layer composition.

### - Polymerization inhibitor -

A small amount of a heat-polymerization inhibitor is preferably added to the photosensitive layer of the present invention in order to inhibit undesired heat polymerization of the polymerizable compound having an ethylenically unsaturated double bond. Preferable examples of the heat-polymerization inhibitor include hydroquinone, p-methoxyphenol, di-t-butyl-p-cresol, pyrogallol, t-butyl catechol, benzoquinone, 4,4'-thiobis(3-methyl-6-t-butyl phenol), 2,2'-methylene bis(4-methyl-6-t-butyl phenol), N-nitrosophenyl hydroxylamine primary cerium salts, etc. The amount of the heat-polymerization inhibitor added is preferably about 0.01 to about 5% by mass relative to the mass of nonvolatile components in the entire composition. To prevent the inhibition of polymerization by oxygen, a higher fatty acid derivative such as behenic acid or behenic amide may be added as necessary so that it is allowed to be locally present on the surface of the photosensitive layer in the drying step after application. The amount of the higher fatty acid derivative added is preferably about 0.5 to about 10% by mass relative to nonvolatile components in the entire photosensitive layer composition.

### - Other additives -

Known additives such as inorganic fillers for improving the physical properties of the cured layer, as well as other plasticizers and sensitizers for improving inking properties on the surface of the photosensitive layer may also be added to the photosensitive layer of the invention. The plasticizers include dioctyl phthalate, didodecyl phthalate, triethylene glycol dicaprylate, dimethyl glycol phthalate, tricresyl phosphate, dioctyl adipate, dibutyl sebacate, triacetyl glycerin, etc., and these can be added in an amount of 10% by mass or less relative to the total mass of the binder polymer and the addition-polymerizable compound.
In the photosensitive layer of the invention, UV initiators and heat-crosslinking agents for enhancing the effect of heating and irradiation after development can also be added for the purpose of improving the layer strength (printing durability) described later.

### [Support]

As a support in the invention, an aluminium support which has been subjected to hydrophilization treatment described later is used. An aluminum plate is better in dimensional stability, is relatively inexpensive, and can provide a surface excellent in hydrophilicity and a strength by optional surface treatment is further preferable. In addition, a composite sheet in which an aluminum sheet is connected on a polyethylene terephthalate film described in JP-B No. 48-18327 is also preferable.

An aluminum plate as a support of the invention is a metal plate containing dimensionally stable aluminum as a main component, and is selected from, in addition to a pure aluminum plate, an alloy plate containing aluminum as a main component and a minor amount of heterogeneous element, and a plastic film or a paper on which aluminum (alloy) is laminated or deposited. In the following explanation, the aforementioned support consisting of aluminum or aluminum alloy, and the like, is collectively referred to as aluminum support for use. As a heterogeneous element contained in the aluminum alloy, there are silicon, iron, manganese, copper, magnesium, chromium, zinc, bismuth, nickel and titanium, and a content of a heterogeneous element in an alloy is 10 % by mass or less. In the invention, a pure aluminum plate is preferable, but since completely pure aluminum is difficult to prepare from a viewpoint of refining technique, a heterogeneous element may be slightly contained. Like this, an aluminum plate applied to the invention is not specified in its composition, but the previously known and used material, for example, JIS A 1050, JIS A 1100, JIS A 3103, and JIS A 3005 can be appropriately utilized.

The thickness of the aluminum support is about 0.1 to 0.6 mm. This thickness can be suitably changed depending on the size of a printing machine, the size of a printing plate, and user's demands.
The aluminum support may be subjected to support surface treatment described later and be hydrophilicity-conferred.

### (Surface roughening treatment)

The surface roughening treatment includes mechanical roughening, chemical etching and electrolytic grain as disclosed in JP-A No. 56-28893. Use can also be made of an electrochemical surface roughening method for electrochemical surface roughening in a hydrochloric acid or nitric acid electrolyte and mechanical surface roughening methods such as a wire blush grain method of scratching an aluminum surface with a metallic wire, a pole grain method of graining an aluminum surface with abrasive grains ball and an abrasive and a brush grain method of surface roughening with a nylon brush and an abrasive, and these surface roughening methods can be used singly or in combination thereof.. Among these methods, the electrochemical method of chemical surface roughening in a hydrochloric acid or nitric acid electrolyte is particularly useful in surface roughening, and the suitable anodizing electrical quantity is in the range of 50 to 400 C/dm². Specifically, alternating current and/or direct current electrolysis is conducted preferably at a temperature of 20 to 80°C, for 1 second to 30 minutes and at a current density of 100 to 400 C/dm² in an electrolyte containing 0.1 to 50% hydrochloric acid or nitric acid.

The aluminum support thus surface-roughened may be etched chemically with an acid or an alkali. Preferable examples of the etching agent include sodium hydroxide, sodium carbonate, sodium aluminate, sodium metasilicate, sodium phosphate, potassium hydroxide, lithium hydroxide etc., and the concentration and temperature are preferably in the range of 1 to 50% and 20 to 100°C, respectively. After etching, washing with an acid is carried out to remove smuts remaining on the surface. The acid used includes nitric acid, sulfuric acid, phosphoric acid, chromic acid, fluoric acid and borofluoric acid. After electrochemical roughening treatment, the method of removing smuts is preferably a method of contacting with sulfuric acid of 15 to 65% by mass at a temperature of 50 to 90°C as described in JP-A No. 53-12739 and a method of alkali etching as described in JP-B No. 48-28123. The method and conditions are not limited insofar as the central line average roughness Ra of the treated surface after the above-described treatment is 0.2 to 0.5 µm.

### (Anodizing treatment)

The thus treated aluminum support having an oxide layer formed thereon is then subjected to anodizing treatment.

In the anodizing treatment, an aqueous solution of sulfuric acid, phosphoric acid, oxalic acid and/or boric acid-sodium borate can be used as the major component in an electrolytic bath. In this case, the electrolyte may contain at least components usually contained in an Al alloy plate, electrode, tap water and underground water. Second and third components may also be contained. The second and third components include, for example, metal ions such as Na, K, Mg, Li, Ca, Ti, Al, V, Cr, Mn, Fe, Co, Ni, Cu and Zn, ammonium ions, and anions such as nitrate ion, carbonate ion, chlorine ion, phosphate ion, fluorine ion, sulfite ion, titanate ion, silicate ion and borate ion, and these may be contained at a concentration of 0 to 10000 ppm.
Although the conditions for anodizing treatment are not particularly limited, the plate is treated preferably with 30 to 500 g/L solution at a temperature of 10 to 70°C by direct current or alternating current electrolyte in the range of a current density of 0.1 to 40 A/m². The thickness of the anodized layer formed is in the range of 0.5 to 1.5 µm.
Preferably, the thickness is in the range of 0.5 to 1.0 µm. The treatment conditions should be selected such that the pore diameter of micropores present in the anodized layer formed on the support by the treatment described above is 5 to 10 nm and the pore density is 8 × 10¹⁵ to 2 × 10¹⁶ pores/m².

For treatment for conferring hydrophilicity on the surface of the support, various known methods can be used. The treatment is particularly preferably hydrophilicity-conferring treatment with silicate or polyvinylphosphonic acid. The layer is formed from an Si or P element in an amount of 2 to 40 mg/m², preferably 4 to 30 mg/m². The coating amount can be measured by fluorescence X ray analysis.

In the hydrophilicity-conferring treatment, the aluminum support having an anodized layer formed thereon is dipped in an aqueous solution at pH 10 to 13 (determined at 25°C) containing an alkali metal silicate or polyvinylphosphonic acid in an amount of 1 to 30% by mass, more preferably 2 to 15% by mass, for example at 15 to 80°C for 0.5 to 120 seconds.

As the alkali metal silicate used in the hydrophilicization treatment, sodium silicate, potassium silicate, lithium silicate etc. are used. The hydroxide used for raising the pH value of the aqueous alkali metal silicate solution includes sodium hydroxide, potassium hydroxide, lithium hydroxide etc. Alkaline earth metal salts or the group IVB metal salts may be incorporated into the treating solution described above. The alkaline earth metal salts include nitrates such as calcium nitrate, strontium nitrate, magnesium nitrate and barium nitrate, and water-soluble salts such as sulfate, hydrochloride, phosphate, acetate, oxalate and borate. The group IVB metal salts include titanium tetrachloride, titanium trichloride, titanium potassium fluoride, titanium potassium oxalate, titanium sulfate, titanium tetraiodide, zirconium chloride oxide, zirconium dioxide, zirconium oxychloride, zirconium tetrachloride, etc.

The alkaline earth metal salts or the group IVB metal salts can be used singly or in combination thereof. The amount of these metal salts is preferably in the range of 0.01 to 10% by mass, more preferably 0.05 to 5.0% by mass. Silicate electrodeposition as described in US Patent No. 3,658,662 is also effective. A support subjected to electrolytic grain as disclosed in JP-B No. 46-27481, JP-A Nos. 52-58602 and 52-30503, and surface treatment comprising the anodizing treatment in combination with the hydrophilicity-conferring treatment, are also useful.

### [Production of the planographic printing plate precursor]

The planographic printing plate precursor of the invention is produced by disposing the photosensitive layer and the protective layer in this order and, as required, an undercoat layer on a support. Such a planographic printing plate precursor may be produced by dissolving each coating solution containing the above various components in a proper solvent and by applying the obtained coating solutions one by one to a support.

When the photosensitive layer is arranged by coating, the components for the photosensitive layer is dissolved in various organic solvents to obtain a photosensitive layer coating solution, and the coating solution is applied onto the support or the intermediate layer.
The solvent used includes acetone, methyl ethyl ketone, cyclohexane, ethyl acetate, ethylene dichloride, tetrahydrofuran, toluene, ethylene glycol monomethyl ether, ethylene glycol monoethyl ether, ethylene glycol dimethyl ether, propylene glycol monomethyl ether, propylene glycol monoethyl ether, acetyl acetone, cyclohexanone, diacetone alcohol, ethylene glycol monomethyl ether acetate, ethylene glycol ethyl ether acetate, ethylene glycol monoisopropyl ether, ethylene glycol monobutyl ether acetate, 3-methoxy propanol, methoxy methoxy ethanol, diethylene glycol monomethyl ether, diethylene glycol monoethyl ether, diethylene glycol dimethyl ether, diethylene glycol diethyl ether, propylene glycol monomethyl ether acetate, propylene glycol monoethyl ether acetate, 3-methoxy propyl acetate, N,N-dimethyl formamide, dimethyl sulfoxide, γ-butyrolactone, methyl lactate and ethyl lactate. These solvents can be used singly or in combination. The solid content of the photosensitive layer coating solution is suitably 2 to 50% by mass.

The coating amount of the photosensitive layer mainly affects the sensitivity and developability of the photosensitive layer and the strength and printing durability of the layer exposed to light, and is desirably selected depending on the use. When the coating amount is too low, the printing durability is not sufficient. It is not preferable for the coating amount to be too high because sensitivity is reduced, light exposure requires more time, and a longer time is necessary for development processing. The coating amount on the planographic printing plate precursor for scanning light exposure as the major object of the present invention is preferably in the range of about 0.1 to 10 g/m², and more preferably 0.5 to 5 g/m², in terms of dried weight.

### [Intermediate layer (undercoating layer)]

In the planographic printing plate precursor of the invention, an intermediate layer (undercoating layer) may be disposed between a photosensitive layer and a support for the purpose of improving adherability and contaminating property. Specific examples of such the intermediate layer include those described in JP-B No. 50-7481, JP-A No. 54-72104, JP-A No. 59-101651, JP-A No. 60-149491, JP-A No. 60-232998, JP-A No. 3-56177, JP-A No. 4-282637, JP-A No. 5-16558, JP-A No. 5-246171, JP-A No. 7-159983, JP-A No. 7-314937, JP-A No. 8-202025, JP-A No. 8-320551, JP-A No. 9-34104, JP-A No. 9-236911, JP-A No. 9-269593, JP-A No. 10-69092, JP-A No. 10-115931, JP-A No. 10-161317, JP-A No. 10-260536, JP-A No. 10-282682, JP-A No. 11-84674, JP-ANo. 10-69092, JP-ANo. 10-115931, JP-ANo. 11-38635, JP-ANo. 11-38629, JP-A No. 10-282645, JP-A No. 10-301262, JP-A No. 11-24277, JP-A No. 11-109641, JP-ANo. 10-319600, JP-ANo. 11-84674, JP-ANo. 11-327152, JP-ANo. 2000-10292, JP-ANo. 2000-235254, JP-A No. 2000-352854, JP-A No. 2001-209170, and Japanese Patent Application No. 11-284091.

### <Plate-making method>

A method of making a planographic printing plate of the invention will be explained below.

A method of making the planographic printing plate of the invention comprises setting a stack in which a plurality of the planographic printing plate precursors of the invention are stacked while a protective layer and a back of an aluminum support are directly contacted, in a plate setter, automatically conveying one by one of the planographic printing plate precursors, subjecting the planographic printing plate precursors to exposing treatment at a wavelength of 750 nm to 1400 nm, and performing developing treatment under condition of a conveying rate of 1.25 m/min or more substantially without via heat treatment.

The planographic printing plate precursor of the invention can be applied to the aforementioned plate-making method because adherability between planographic printing plate precursors, and occurrence of a flaw on a protective layer are suppressed even when precursors are stacked without holding a set-off sheet therebetween.

According to the method of making a planographic printing plate of the invention, since a stack in which planographic printing plate precursors are stacked without holding a set-off sheet therebetween is used, it becomes unnecessary to remove a set-off sheet, and productivity in a plate-making step is improved.

It goes without saying that this plate-making method is also preferable for plate making of the planographic printing plate precursor of the invention, and can be preferably applied to all of planographic printing plate precursors provided with a polymerizable negative-type photosensitive layer containing at least an infrared absorbing agent, a polymerization initiator and a polymerizable compound, and having solubility in an alkali developer which is reduced by exposure to a wavelength of 750 nm to 1400 nm. Specifically, a photosensitive layer may be a photosensitive layer containing respective components of "infrared absorbing agent, polymerization initiator, and polymerizable compound" explained in item of respective components constituting a photosensitive layer of the planographic printing plate precursor of the invention, and may or may not contain the known binder polymer.

It is preferable that a photosensitive layer to which the method of making a planographic printing plate of the invention is applied has physical property of a developing rate at an unexposed part for an alkali developer having a pH of 10 to 13.5, of 80 nm/sec or more, and a permeating rate at an exposed part of the alkali developer, of 50 nF/sec or less. As a method of measuring this developing rate at an unexposed part of a photosensitive layer and a permeating rate of an alkali developer into a photosensitive layer after curing, a method described in Japanese Patent Application No. 2004-248535 which was previously filed by the present applicant can be used. Control of a developing rate at an unexposed part of a photosensitive layer and a permeating rate of an alkali developer into a photosensitive layer after curing can be performed by a conventional method, and a representative method is a method of using the aforementioned particular binder polymer and, additionally, for improving a developing rate at an unexposed part, addition of a hydrophilic compound is useful and, for suppressing permeation of a developer into an exposed part, addition of a hydrophobic compound is useful.

### [Light Exposure]

Any light source can be used as the light source used in the light exposure, insofar as it can emit light at a wavelength of 750 nm to 1400 nm. Preferable examples thereof include an IR laser. The planographic printing plate precursor of the present invention is preferably imagewizely exposed with infrared ray having a wavelength of 750 nm to 1400 nm emitted by a solid laser or a semiconductor laser. The output power of the laser is preferably 100 mW or more, and a multi-beam laser device is preferably used to reduce the light exposure time. The light exposure time per pixel is preferably within 20 µsec. The energy irradiated on the planographic printing plate precursor is preferably 10 to 300 mJ/cm². When the energy for light exposure is too low, the curing of the photosensitive layer does not sufficiently proceed. When the energy for light exposure is too high, the photosensitive layer may be ablated with the laser to damage the image.

The light exposure method in the invention can be carried out by overlapping beams from a light source. The term "overlapping" means that the distance between beam centers in the sub-scanning direction is smaller than the beam diameter. For example, when the beam diameter is expressed in terms of full-width half-maximum (FWHM), the overlapping can be quantitatively expressed as FWHM/distance between beam centers in the sub-scanning direction (i.e., overlapping coefficient). The overlapping coefficient in the present invention is preferably 0.1 or more.

The scanning system using a light source in the light exposure device of the present invention is not particularly limited, and known scanning methods such as a drum outer surface scanning method, a drum inner surface scanning method or a flatbed scanning method can be used. The channel of the light source may be single or multi-channel, but in the case of the drum outer surface scanning method, a multi-channel is preferably used.

In the invention, the exposed planographic printing plate precursor is subjected to development treatment without carrying out any particular heat treatment and water-washing treatment as mentioned above. No practice of this heat treatment enables suppression of image non-uniformity caused by the heat treatment. Also, no practice of these heat treatment and water-washing treatment enables stable high-speed treatment in development treatment.

### [Development]

In developing treatment of the planographic printing plate precursor of the invention, a non-image part of a photosensitive layer is removed using a developer.

A developer used in the invention will be explained below.

### (Developer)

A developer used in the invention is preferably an alkali aqueous solution having a pH of 14 or less, and preferably contains an aromatic anionic surfactant.

### (Aromatic anionic surfactant)

An aromatic anionic surfactant used in a developer of the planographic printing plate precursor of the invention has the development promoting effect, and the effect of stabilizing dispersion of polymerizable negative-type photosensitive layer components and protective layer components in a developer, and this is preferable in stabilizing developing treatment. Inter alia, it is preferable that an aromatic anionic surfactant used in the planographic printing plate precursor of the invention is a compound represented by the following formula (A) or the formula (B).

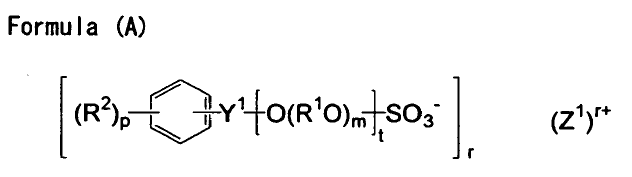

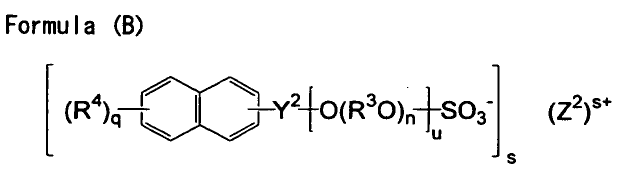

In the formula (A) or the formula (B), R¹ and R³ each represent independently a straight or branched alkylene group of a carbon number of 1 to 5, specifically, examples include an ethylene group, a propylene group, a butylene group, and a pentylene group and, inter alia, an ethylene group and a propylene group are particularly preferable.

And, m and n each represent independently an integer selected from 1 to 100 and, inter alia, 1 to 30 is preferable, and 2 to 20 is more preferable. When m is 2 or more, plural R¹s may be the same or different. Similarly, when n is 2 or more, plural R³s may be the same or different.

And, t and u each represent independently 0 or 1.

R² and R⁴ each represent independently a straight or branched alkyl group of a carbon number of 1 to 20, examples include a methyl group, an ethyl group, a propyl group, a butyl group, a hexyl group, and a dodecyl group and, inter alia, a methyl group, an ethyl group, an iso-propyl group, a n-propyl group, a n-butyl group, an iso-butyl group, and a tert-butyl group are particularly preferable.

And, p and q each represent an integer selected from 0 to 2. Y¹ and Y² each represent a single bond or an alkylene group of a carbon number of 1 to 10, specifically, a single bond, a methylene group and an ethylene group are preferable, and a single bond is particularly preferable.

(Z¹)^{r+} and (Z²)^{s+} each represent independently an alkali metal ion, an alkaline earth metal ion, or an ammonium ion which is substituted or not substituted with an alkyl group, examples include a lithium ion, a sodium ion, a potassium ion, a magnesium ion, a calcium ion, an ammonium ion, and a secondary to quaternary ammonium ion substituted with an alkyl group, an aryl group or an aralkyl group in a range of a carbon number of 1 to 20 and, particularly, a sodium ion is preferable. And, r and s each represent 1 or 2.

Embodiments are shown below, but the invention is not limited to them.

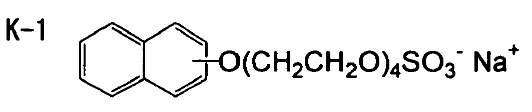

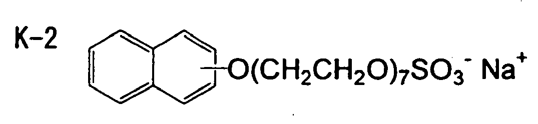

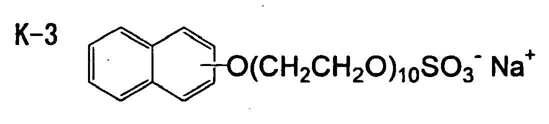

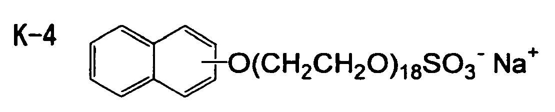

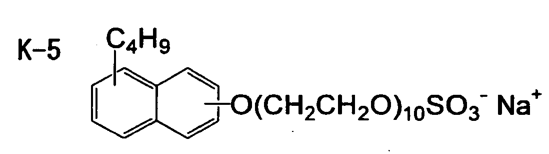

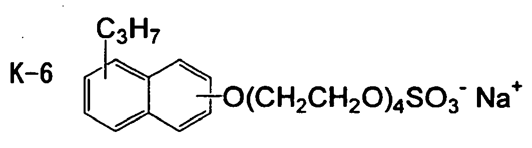

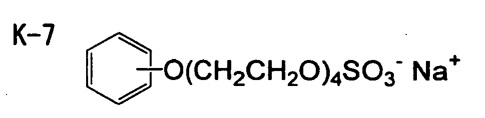

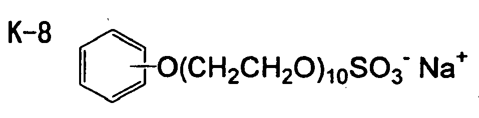

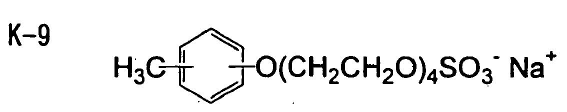

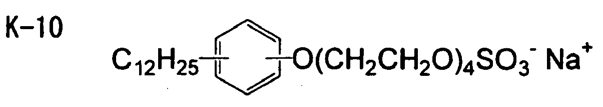

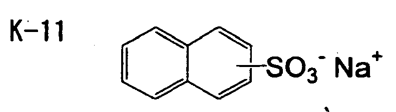

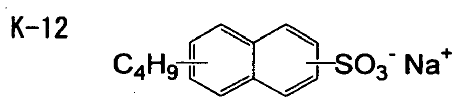

These aromatic anionic surfactants may be used either independently or in combinations of two or more. As to the amount of the aromatic anionic surfactant, it is effective to design the amount of the surfactant to be preferably in a range from 1.0 to 10% by mass and more preferably in a range from 2 to 10% by mass. Here, if the content of the surfactant is less than 1.0% by mass, this brings about reductions in developing characteristics and the solubility of the photosensitive layer component. If the content is 10% by mass or more, the printing durability of the printing plate is reduced.

The developing solution according to the invention may use, in addition to the above aromatic anionic surfactant, other surfactants together. Given as examples of these other surfactants are nonionic surfactants including polyoxyethylene alkyl ethers such as polyoxyethylene naphthyl ether, polyoxyethylene alkylphenyl ether, polyoxyethylene lauryl ether, polyoxyethylene cetyl ether and polyoxyethylene stearyl ether, polyoxyethylene alkyl esters such as polyoxyethylene stearate, sorbitan alkyl esters such as sorbitan monolaurate, sorbitan monostearate, sorbitan distearate, sorbitan monooleate, sorbitan sesquioleate and sorbitan trioleate and monoglyceride alkyl esters such as glycerol monostearate and glycerol monooleate.

The content of these other surfactants in the developing solution is 0.1 to 10% by mass based on the amount of effective components.

### (Chelating agent for divalent metals)

The developing solution according to the invention is preferably made to contain a chelating agent for a divalent metal with the intention to suppress the influences of, for example, calcium ions contained in hard water. Examples of the chelating agent for a divalent metal include polyphosphates such as Na₂P₂O₇, Na₅P₃O₃, Na₃P₃O₉, Na₂O₄P (NaO₃P)PO₃Na₂ and Calgon (sodium polymethaphosphate); aminopolycarboxylic acids such as ethylenediaminetetraacetic acid and its potassium salts, sodium salts and amine salts, diethylenetriaminepentaacetic acid and its potassium salts and sodium salts, triethylenetetraminehexaacetic acid and its potassium salts and sodium salts, hydroxyethylethylenediaminetriacetic acid and its potassium salts and sodium salts, nitrilotriacetic acid and its potassium salts and sodium salts, 1,2-diaminocyclohexanetetraacetic acetic acid and its potassium salts and sodium salts, and 1,3-diamino-2-propanoltetraacetic acid and its potassium salts and sodium salts; and organic phosphonic acids such as 2-phosphono-1,2,4-butanetricarboxylic acid and its potassium salts and sodium salts, 2-phosphono-2,3,4-butanetricarboxylic acid and its potassium salts and sodium salts, 1-phosphono-1,2,2-ethanetricarboxylic acid and its potassium salts and sodium salts, 1-hydroxyethane-1,1-diphosphonic acid and its potassium salts and sodium salts, and aminotri(methylenephosphonic acid) and its potassium salts and sodium salts. Among these compounds, ethylenediaminetetraacetic acid and its potassium salts, sodium salts and amine salts, ethylenediaminetetra(methylenephosphonic acid) and its ammonium salts and potassium salts; and hexamethylenediaminetetra(methylenephosphonic acid) and its ammonium salts and potassium salts are preferable.

The optimum amount of the chelating agent varies corresponding to the hardness and amount of hard water to be used. However, the chelating agent is contained in an amount of generally 0.01 to 5% by mass and preferably 0.01 to 0.5% by mass in the developing solution during use.

Also, alkali metal salts of organic acids or inorganic acids may be added as developing regulators to the developing solution according to the invention. For example, sodium carbonate, potassium carbonate, ammonium carbonate, sodium citrate, potassium citrate and ammonium citrate may be used singly or in combinations of two or more.

### (Alkali agent)

Examples of the alkali agent used in the developing solution according to the invention include inorganic alkali agents such as sodium tertiary phosphate, potassium tertiary phosphate, ammonium tertiary phosphate, sodium borate, potassium borate, ammonium borate, sodium hydroxide, potassium hydroxide, ammonium hydroxide and lithium hydroxide and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine and tetramethylammoniumhydroxide. In the invention, these compounds may be used either singly or in combinations of two or more.

Also, examples of alkali agents other than the above agents may include alkali silicates. These alkali silicates may be used in combination with a base. Examples of the alkali silicates to be used are those exhibiting alkalinity when dissolved in water and include sodium silicate, potassium silicate, lithium silicate and ammonium silicate. These silicates may be used either singly or in combinations of two or more.

The developing solution used in the invention may be easily adjusted to an optimum range by controlling the mixing ratio of silicon oxide SiO₂ which is a component of silicate (silicate is a component to impart hydrophilicity to the support) to an alkali oxide M₂O (M represents an alkali metal or an ammonium group) which is an alkali component, and the concentrations of these components. The mixing ratio (molar ratio of SiO₂/M₂O) of silicon oxide SiO₂ to an alkali oxide M₂O is preferably in a range from 0.75 to 4.0 and more preferably in a range from 0.75 to 3.5 from the viewpoint of suppressing the occurrence of stains caused by excess dissolution (etching) of an anodic oxide film of the support and generation of insoluble gas caused by the formation of a complex of dissolved aluminum and a silicate.

Also, the concentration of the alkali silicate in a developing solution is preferably in a range from 0.01 to 1 mol/L and more preferably in a range from 0.05 to 0.8 mol/L as the amount of SiO₂ based on the mass of the developing solution from the viewpoint of the effect of suppressing dissolution (etching) of an anodic oxide film of the support, developing ability, the effect of suppressing precipitation and generation of crystals and the effect of preventing gelation when developing solution waste is neutralized.

The developing solution used in the invention may use the following components together according to the need besides the above components. Examples of these components include organic carboxylic acids such as benzoic acid, phthalic acid, p-ethylbenzoic acid, p-n-propylbenzoic acid, p-isopropylbenzoic acid, p-n-butylbenzoic acid, p-t-butylbenzoic acid, p-2-hydroxyethylbenzoic acid, decanoic acid, salicylic acid and 3-hydroxy-2-naphthoic acid; organic solvents such as propylene glycol; and others including reducing agents, dyes, pigments, water softeners and antiseptics.

The developing solution used in the invention has a pH in a range from preferably 10 to 12.5 and more preferably 11 to 12.5 at 25°C. Since the developing solution of the invention contains the aforementioned surfactant, excellent developing characteristics are developed in the non-image arae even if a developing solution having such low pH is used. Such a measures as to make the developing solution have a lower pH reduces damages to the image area during developing and improves the handling characteristics of the developing solution.

Also, the conductivity x of the developing solution preferably satisfies the equation 2 < x < 30 mS/cm and is more preferably 5 to 25 mS/cm.

Here, it is preferable to add alkali metal salts of organic acids or inorganic acids as conductive regulators that regulate conductivity.

The above developing solution may be used as a developing solution for an exposed planographic printing plate precursor and as a developing replenishing solution and is preferably applied to an automatic developing machine. In the case of carrying out developing using an automatic developing machine, the developing solution is exhausted corresponding to the throughput and a replenishing or fresh developing solution may be therefore used to recover developing capability. This replenishing system is also preferably applied in the plate-making method of the invention.

In order to recover the developing capability of the developing solution by using an automatic developing machine, it is preferable to replenish using a method as described in U.S.Patent No. 4,882,246. Developing solutions as described in each publication of JP-A Nos. 50-26601 and 58-54341 and JP-B Nos. 56-39464, 56-42860 and 57-7427 are also preferable.

A more preferable development replenisher in the invention is a development replenisher characterized in that it contains an oxycarboxylic acid chelating agent having a water-soluble chelate compound forming ability with an aluminum ion, alkali metal hydroxide, and a surfactant, does not contain silicate, and is an aqueous solution having a pH of 11 to 13.5. By using such the development replenisher, such the property is possessed that excellent developability and a strength of an image part of a printing material are not deteriorated, precipitation of aluminum hydroxide formed by dissolution of an aluminum support by an alkali of a developer is effectively suppressed, adhesion of a stain having aluminum hydroxide as a main component onto a surface of a developing bath roller of an automatic developing machine and, subsequently, accumulation of aluminum hydroxide precipitate in a water washing bath are reduced, and treatment can be stably performed for a long period of time.

The planographic printing plate precursor developed in this manner is subjected to after-treatment performed using rinsing water, a rinsing solution containing surfactants and the like and a protective gum solution containing gum arabic and a starch derivative as its major components. For the after-treatment of the planographic printing plate precursor of the present invention, these treatments are used in various combinations. The planographic printing plate obtained by such treatments is placed in an offset printer and used for printing a number of copies.

In the method of making a planographic printing plate according to the invention, the developed image may be subjected to after-heating treatment and exposure performed on the entire surface for the purpose of improving image strength and printing durability.

Very strong conditions can be utilized in the heating after the image is developed. The heating is usually carried out at a temperature in a range from 200 to 500°C. If the heating temperature after the development treatment is too low, only an insufficient image strengthening effect is obtained whereas if the heating temperature is too high, there are fears of a deterioration of the support and thermal decomposition of the image area.

The planographic printing plate obtained by such treatments is placed in an offset printer and used for printing a number of copies.

As the plate cleaner used to remove stains on the plate during printing, a conventionally known plate cleaner for PS plate is used. Examples of the plate cleaner include CL-1, CL-2, CP, CN-4, CN, CG-1, PC-1, SR and IC (manufactured by Fuji Photo Film Co., Ltd.).

The present invention will be explained in more detail by way of examples, which, however, should not be construed to limit the scope of the invention.

### Example 1

### (Production of a support)

A 0.30-mm-thick and 1030-mm-wide JIS A1050 aluminum plate was used to carry out the following surface treatment

### < Surface treatment >

In the surface treatment, the following various treatments (a) to (f) were continuously carried out. After each treatment and washing, a nip roller was used to drain off.
(a) The aluminum plate was subjected to etching treatment carried out in the following condition: concentration of caustic soda: 26% by mass, concentration of ammonium ions: 6.5% by mass and temperature: 70°C, to dissolve 5 g/m² of the aluminum plate, followed by washing with water.
(b) The aluminum plate was subjected to de-smutting treatment carried out using an aqueous 1 mass % nitric acid solution (including 0.5% by mass of aluminum ions) kept at 30°C by spraying, followed by washing with water.
(c) The aluminum plate was subjected to electrochemical surface roughing treatment carried out continuously by using 60 Hz a.c. current. The electrolytic solution used at this time was an aqueous 1 mass % nitric acid solution (including 0.5% by mass of aluminum ions and 0.07 % by mass of ammonium ions) kept at 30°C.
   Electrochemical surface roughening treatment was carried out by using an a.c. power source with a trapezoidal rectangular wave a.c. current having the following characteristics: the time TP required for the current to reach a peak from zero: 2 msec and duty ratio: 1 : 1 and also using a carbon electrode as the counter electrode. Ferrite was used as the auxiliary anode. The current density was 25 A/dm² when the current reached a peak and the quantity of electricity was 250 C/cm² as the sum of the quantity of electricity when the aluminum plate served as the anode. 5% of the current flowing from the power source was distributed to the auxiliary anode and then the aluminum plate was washed with water.
(d) The aluminum plate was subjected to etching treatment carried out by spraying in the following condition: concentration of caustic soda: 26% by mass, concentration of ammonium ions: 6.5% by mass and temperature: 35°C, to dissolve 0.2 g/m² of the aluminum plate, to thereby remove the smut component which was produced when the electrochemical surface roughening treatment using a.c. current in the previous stage and primarily contained aluminum hydroxide and to dissolve the edge part of the generated pit, thereby smoothing the edge part. Then, the aluminum plate was washed with water.
(e) The aluminum plate was subjected to de-smutting treatment carried out using an aqueous 25 mass % sulfuric acid solution (including 0.5% by mass of aluminum ions) kept at 60°C by spraying, followed by washing with water.
(f) The aluminum plate was subjected to anodic oxidation treatment in the following condition: concentration of sulfuric acid: 170 g/l (containing 0.5% by mass of aluminum ions), temperature: 33°C and current density: 5 (A/dm²), for 50 seconds, followed by washing with water. The weight of the anodic oxide film at this time was 2.7 g/m².

The surface roughness Ra of the aluminum support obtained in this manner was 0.27 (measuring device: SURFCOM, manufactured by TOKYO SEIMITSU Co., Ltd., diameter of the tracer head: 2 mµ).

### < Undercoat layer >

Next, the following undercoat layer coating solution was applied to this aluminum support by using a wire bar and dried at 90°C for 30 minutes. The amount applied was 10 mg/m².

### (Undercoat layer coating solution)

| | |
|---|---|
| · High-molecular compound A having the following structure | 0.05 g |
| · Methanol | 27 g |
| · Ion exchange water | 3 g |

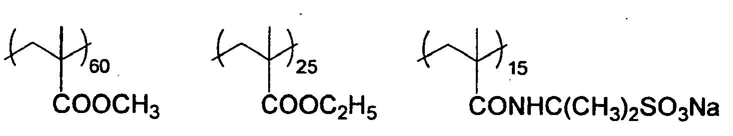

### (Photosensitive layer)

Then, the following photosensitive layer coating solution [P-1] was prepared, and coated on the aluminum support described above using a wire bar. Drying was performed with a warm air drying device at 115°C for 34 seconds to obtain a planographic printing plate precursor. A covering amount after drying was 1.4 g/m².

### <Photosensitive layer coating solution [P-1]>

| | |
|---|---|
| ·Infrared absorbing agent (IR-1) | 0.074 g |
| ·Polymerization initiator (OS-12) | 0.280 g |
| ·Additive (PM-1) | 0.151 g |
| ·Polymerizable compound (AM-1) | 1.00 g |
| ·Particular binder polymer (BT-1) | 1.00 g |
| ·Ethyl violet (C-1) | 0.04 g |
| ·Fluorine-based surfactant | 0.015 g |
| (trade name MEGAFACK F-780-F, manufactured by Dainippon Ink and Chemicals, Incorporated, 30 mass% solution in methyl isobutyl ketone (MIBK)) | |
| ·Methyl ethyl ketone | 10.4 g |
| ·Methanol | 4.83 g |
| ·1-Methoxy-2-propanol | 10.4 g |

The polymerization initiator (OS-12) used in the aforementioned photosensitive layer coating solution refers to a polymerization initiator listed as a compound example of an onium salt represented by the formula (1). Structures of the infrared absorbing agent (IR-1), the additive (PM-1), the polymerizable compound (AM-1), the binder polymer (BT-1), and the ethyl violet (C-1) are shown below.

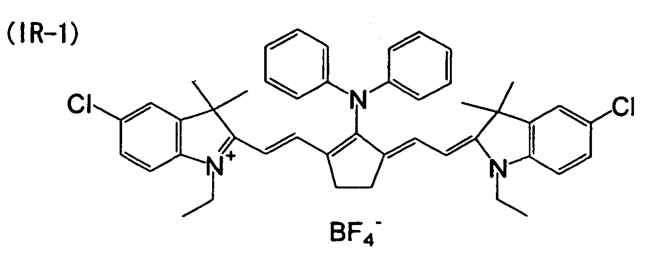

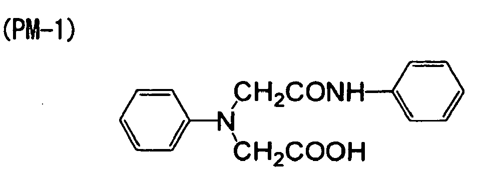

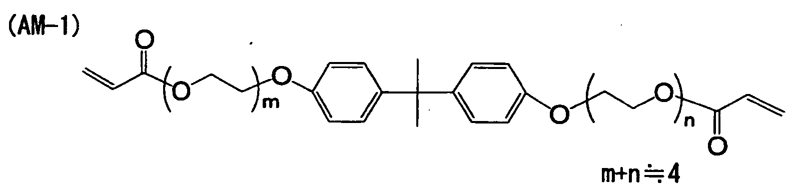

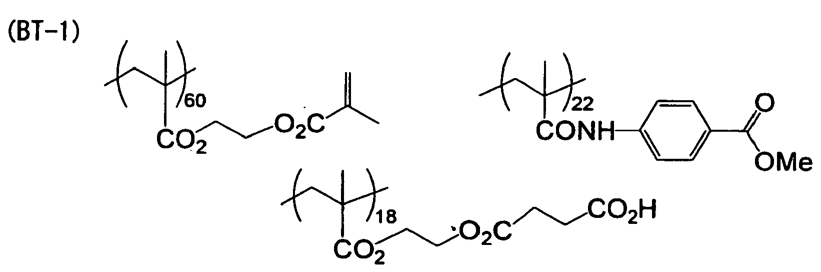

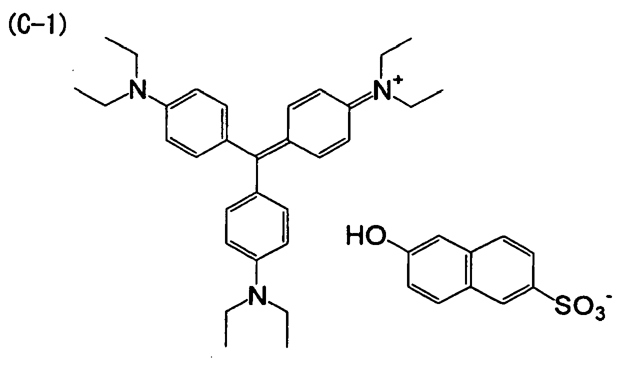

### (Protective layer)

A mixed aqueous solution (coating solution for protective layer) of specified polyvinyl alcohol having a saponification degree of 91 mol% or more (trade name: PVA-105, manufactured by Kuraray Co., Ltd.: saponification degree 98.5 mol%, polymerization degree 500), Pluronic P-84 (manufactured by ADEKA CORPORATION, ethylene oxide/propylene oxide copolymer) and a surfactant (trade name EMULLEX 710, manufactured by Nihon-emulsion Co., Ltd.) was coated on a surface of the photosensitive layer with a wire bar, and dried with a warm air drying device at 125°C for 75 seconds to prepare a protective layer.

A content ratio of specified polyvinyl alcohol/Pluronic P-84/surfactant in this mixed aqueous solution (coating solution for protective layer) was 92/6/2 (% by mass), and a total coating amount (covering amount after drying) was 1.6 g/m².

Oxygen permeability of this protective layer at 25°C, 60 %RH and 1 atm was measured, and found to be 10.7 ml/m²·day.

For measuring oxygen permeability, an oxygen shielding layer was coated on an about 200µm photographic paper, on both sides of which were coated with about 20µm polyethylene, as in coating on a photosensitive layer, and this was dried to prepare a sample for measuring oxygen permeability. Since oxygen permeability of a photographic paper is about 700 ml/m²·day·atm under the following condition, this can be sufficiently neglected in measuring an oxygen shielding layer.

According to a gas permeability test method described in JIS K7126B and ASTM D3985, the disclosure of which are incorporated by reference herein, the sample was measured for oxygen permeability ml/(m²·day·atm) under condition of 25°C and 60 %RH using OX-TRAN2/20 manufactured by Mocon.

Thereby, the planographic printing plate precursor of Example 1 was obtained.

### [Examples 2 to 6]

According to the same manner as that of Example 1 except that a kind and an addition amount of ethylene oxide/propylene oxide copolymer, and a kind of a binder component (specified polyvinyl alcohol) were changed as in the following Table 1 in a composition of the mixed aqueous solution (coating solution for protective layer) of Example 1, planographic printing plate precursors of Examples 2 to 6 were obtained.

### [Comparative Example 1]

According to the same manner as that of Example 1 except that a coating solution was changed to a coating solution to which an ethylene oxide/propylene oxide copolymer was not added in a mixed aqueous solution (coating solution for protective layer) of Example 1, the planographic printing plate precursor of Comparative Example 1 was obtained.

### [Comparative Example 2]

According to the same manner as that of Example 1 except that 6.0 % by mass of polyvinylpyrrolidone (K-30) was added in place of a copolymer of ethylene oxide and propylene oxide in the mixed aqueous solution (coating solution for protective layer) of Example 1, the planographic printing plate precursor of Comparative Example 2 was obtained.

**Table 1**

| | Protective layer | | | | |
|---|---|---|---|---|---|
| | Polyvinyl alcohol | | Copolymer of ethylene oxide and propylene oxide | Coating amount (g/m²) | Oxygen permeability (ml/m²·day) |
| | Product name | Saponification degree | Product name | | |
| Example 1 | PVA-105 | 98.5 mol% | Pluronic P-84 | 1.6 | 10.7 |
| Example 2 | NM-11 | 99 mol% | Pluronic P-84 | 2.30 | 8.2 |
| Example 3 | JF-05 | 98.5 mol% | Pluronic P-84 | 2.30 | 11.6 |
| Example 4 | PVA-105 | 98.5 mol% | Pluronic L-64 | 2.30 | 12.2 |
| Example 5 | PVA-105 | 98.5 mol% | Pluronic P-85 | 2.30 | 10.3 |
| Example 6 | PVA-105 | 98.5 mol% | Pluronic F-88 | 2.30 | 10.4 |
| Comparative Example 1 | PVA-105 | 98.5 mol% | None | 2.30 | 0.41 |
| Comparative Example 2 | PVA-105 | 98.5 mol% | PVP K-30 | 2.30 | 9.7 |

In the Table 1, NM-11 represents completely saponified-type polyvinyl alcohol (trade name GOSENOL NM-11, manufactured by Nippon Synthetic Chemical Industry Co., Ltd.), JF-05 represents completely saponified-type polyvinyl alcohol (manufactured by Japan Vam & Poval Co., Ltd.), Pluronic P-84, L-64, P-85, and F-88 represent an ethylene oxide/propylene oxide copolymer (manufactured by ADEKA CORPORATION.), and PVP K-30 represents polyvinylpyrrolidone (manufactured by ISP (Japan) Ltd.).

### [Assessment]

### (1) Assessment of sensitivity

The resulting planographic printing plate precursor was exposed to light at resolution of 2400 dpi, an external surface drum rotation number of 200 rpm, and in a range of output of 0 to 8 W with Trendsetter 800II Quantum manufactured by Creo by exchanging by 0.15 in terms of logE. Exposure was performed under condition of 25°C and 50 %RH. After exposure, heat treatment and water washing treatment were not performed, and developing treatment was performed at a conveying rate (line rate) of 2 m/min and a developing temperature of 30°C using an automatic developing machine (trade name LP-1310HII manufactured by Fuji Photo Film Co., Ltd.). As a developer, a 1:4 water-diluted solution of DH-N was used, as a developing replenisher, a 1:1.4 water-diluted solution of FCT-421 was used and, as a finisher, a 1:1 water-diluted solution of GN-2K manufactured by Fuji Photo Film Co., Ltd. was used.

As an image part density of the planographic printing plate obtained by development, a cyan concentration was measured with a Macbeth reflection densitometer RD-918 using a red filter equipped in the densitometer. A reciprocal of a necessary light exposure amount for obtaining 0.9 of a measured concentration was adopted as an index for a sensitivity. Regarding assessment results, letting a sensitivity of the planographic printing plate obtained in Example 1 to be 100, a sensitivity of other planographic printing plate was relatively assessed. As a value is larger, a sensitivity is more excellent.

### (2) Assessment of inking property

The resulting planographic printing plate after plate-making treatment was used to perform printing employing a printing machine (trade name DIA I F-2, manufactured by Mitsubishi Heavy Industries, Ltd.), and inking property was assessed by printing numbers from initial printing until a better printed matter is obtained without faded image part ink density. As a printing ink, GRAPH G(N) manufactured by Dainippon Ink and Chemicals, Incorporated was used. As dampening water, IF MARK II manufactured by Fuji Photo Film Co., Ltd. was used. As the printing number until inking is smaller, inking property is more excellent.

### (3) Assessment of adhesion between planographic printing plate precursors (adhesion resistance)

Three of the resulting planographic printing plate precursors (10×10 cm) were moisture-conditioned for 2 hours under the environment of 25°C and 75 %RH, and three precursors were successively stacked in the same direction in the state where they and set-off sheets were stacked alternately, to obtain a stack. This stack was sealing-packaged with an A1 kraft paper, and this was allowed to stand for 5 days under the environment of 30°C in the state where a load of 4 kg was applied. Thereafter, the stack was assessed for the state of adhesion between a surface on a photosensitive layer side (protective layer surface) of a planographic printing plate precursor and an adjacent set-off sheet. Adhesion between the planographic printing plate precursor and the set-off sheet was organoleptically assessed by 1 to 5, 3 is a practically lower limit level, and 2 or less is a practically failure level.

### (4) Assessment of safe light permission time

The resulting planographic printing plate precursor was exposed under a UV-cut fluorescent lamp at an illuminance of 400 Lx for a constant time, and a time until occurrence of fog at a non-image part after developing treatment was compared. As criterion, fog occurrence is defined as a part having a higher concentration by 0.2 or more as compared with a reflection concentration at a non-image part which is not under safe light exposure.

Results of the above assessment are shown in Table 2.

**Table 2**

| | Assessment result | | | |
|---|---|---|---|---|
| | Sensitivity | Inking property | Adhesion resistance | Safe light permission time (min) |
| Example 1 | 100 | 15 | 5 | 100 |
| Example 2 | 100 | 15 | 5 | 100 |
| Example 3 | 100 | 15 | 5 | 100 |
| Example 4 | 100 | 15 | 5 | 100 |
| Example 5 | 100 | 15 | 5 | 100 |
| Example 6 | 100 | 15 | 5 | 100 |
| Comparative Example 1 | 110 | 20 | 5 | 10 |
| Comparative Example 2 | 100 | 75 | 2 | 100 |

As apparent from Table 2, it was seen that planographic printing plate precursors of Example 1 to Example 6, that is, planographic printing plate precursors in which a protective layer containing a copolymer of ethylene oxide and propylene oxide is disposed on a polymerizable negative-type photosensitive layer have a high sensitivity, are also excellent in safe light suitability, further, are excellent in inking property and, even when they are placed under a high humidity, adhesion between planographic printing plate precursors is not observed.

To the contrary, it was seen that the planographic printing plate precursor of Comparative Example 1 not containing a copolymer of ethylene oxide and propylene oxide is excellent in a sensitivity, and adhesion between planographic printing plate precursors is not observed after it was placed under a high humidity, but the precursor is remarkably inferior in safe light suitability.

Similarly, in the planographic printing plate precursor of Comparative Example 2 in which polyvinylpyrrolidone was added in place of a copolymer of ethylene oxide and propylene oxide, a sensitivity was excellent, and safe light suitability was better, but adhesion between a planographic printing plate precursor and a set-off sheet was remarkably inferior after the precursor was placed under a high humidity, and inking property was inferior as compared with planographic printing plate precursors manufactured in Examples 1 to 6.

## Claims

1. A planographic printing plate precursor in which a photosensitive layer and a protective layer are successively laminated on a surface of an aluminum support exhibiting hydrophilicity, **characterized in that** the protective layer contains a binder polymer, and a copolymer of ethylene oxide and propylene oxide,
wherein the binder polymer contained in the protective layer is polyvinyl alcohol having a saponification degree of 91 mole-% or more,wherein a content of the polyvinyl alcohol having a saponification degree of 91 mole-% or more is from 45 to 95 % by mass relative to the total solid matter amount of the protective layer, wherein a content of the copolymer of ethylene oxide and propylene oxide contained in the protective layer is from 2.0 to 15 % by mass relative to the total solid matter amount of the protective layer, and wherein a coating amount of the protective layer is from 0.3 to 3.0 g/m² and wherein the photosensitive layer contains an infrared absorbing agent, a polymerization initiator, a polymerizable compound, and a binder polymer.

2. The planographic printing plate precursor according to claim 1, wherein a content of ethylene oxide contained in the copolymer of ethylene oxide and a propylene oxide contained in the protective layer is from 30 to 80 % by mass.

3. The planographic printing plate precursor according to any one of claims 1 to 2,
wherein oxygen permeability of the protective layer under the environment of 25°C, 65 %RH and 1 atm is from 0.5 ml/m² day to 100 ml/m² day.

4. The planographic printing plate precursor according to claim 1-3, wherein the binder polymer contained in the photosensitive layer is a binder polymer having a repetition unit represented by the following formula (i): 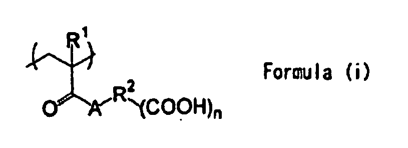 In formula (i), R¹ represents a hydrogen atom or a methyl group, R² represents a tethering group containing 2 or more of atoms selected from the group consisting of a carbon atom, a hydrogen atom, an oxygen atom, a nitrogen atom and a sulfur atom and having the number of those atoms of 2 to 82, A represents an oxygen atom or -NR³ -, R³ represents a hydrogen atom or a monovalent hydrocarbon group of a carbon number of 1 to 10, and n represents an integer of 1 to 5.

## Patentansprüche

1. Flachdruckplattenvorläufer, worin eine fotoempfindliche Schicht und eine Schutzschicht sukzessive auf eine Oberfläche eines Aluminiumträgers, der Hydrophilität zeigt, laminiert sind, **dadurch gekennzeichnet, dass** die Schutzschicht ein Bindemittelpolymer und ein Copolymer von Ethylenoxid und Propylenoxid umfasst,
worin das in der Schutzschicht enthaltene Bindemittelpolymer Polyvinylalkohol mit einem Verseifungsgrad von 91 mol% oder mehr ist, worin der Gehalt des Polyvinylalkohols mit einem Verseifungsgrad von 91 mol% oder mehr 45 bis 95 Masse% beträgt, bezogen auf den Gesamtfeststoffgehalt der Schutzschicht, worin der Gehalt des in der Schutzschicht enthaltenen Copolymers von Ethylenoxid und Propylenoxid 2,0 bis 15 Masse% beträgt, bezogen auf den Gesamtfeststoffgehalt der Schutzschicht, und worin die Beschichtungsmenge der Schutzschicht 0,3 bis 3,0 g/m² beträgt, und worin die fotoempfindliche Schicht einen Infrarotabsorber, einen Polymerisationsinitiator, eine polymerisierbare Verbindung und ein Bindemittelpolymer umfasst.

2. Flachdruckplattenvorläufer gemäß Anspruch 1, worin die Gehalt von Ethylenoxid, die in dem Copolymer von Ethylenoxid und Propylenoxid enthalten ist, welches in der Schutzschicht enthalten ist, 30 bis 80 Massen% beträgt.

3. Flachdruckplattenvorläufer gemäß irgendeinem der Ansprüche 1 bis 2, worin die Sauerstoffdurchlässigkeit der Schutzschicht bei einer Umgebung von 25°, 65 % relativer Luftfeuchtigkeit und 1 Atm 0,5 ml/m²·Tag bis 100 ml/m²·Tag beträgt.

4. Flachdruckplattenvorläufer gemäß Ansprüche 1 bis 3,
worin das in der fotoempfindlichen Schicht enthaltene Bindemittelpolymer ein Bindemittelpolymer ist, das eine durch die folgende Formel (i) dargestellte Wiederholungseinheit aufweist: 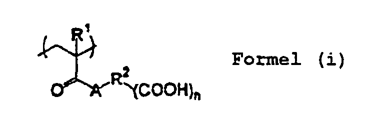 worin in Formel (i) R¹ ein Wasserstoffatom oder eine Methylgruppe darstellt, R² eine verbindende Gruppe darstellt, die 2 oder mehr Atome umfasst, ausgewählt aus der Gruppe bestehend aus Kohlenstoffatomen, Wasserstoffatomen, Sauerstoffatomen, Stickstoffatomen und Schwefelatomen, und worin die Anzahl dieser Atome 2 bis 82 beträgt, A ein Sauerstoffatom oder -NR³- beträgt, R³ ein Wasserstoffatom oder eine monovalente Kohlenwasserstoffgruppe mit einer Kohlenstoffanzahl von 1 bis 10 darstellt und n eine ganze Zahl von 1 bis 5 darstellt.

## Revendications

1. Précurseur de plaque d'impression planographique dans lequel une couche photosensible et une couche de protection sont successivement stratifiées sur une surface d'un support en aluminium présentant de l'hydrophilicité, **caractérisé en ce que** la couche de protection contient un polymère de liaison, et un copolymère d'oxyde d'éthylène et d'oxyde de propylène,
dans lequel le polymère de liaison contenu dans la couche de protection est un alcool polyvinylique ayant un degré de saponification de 91 % en mole ou davantage, dans lequel une teneur de l'alcool polyvinylique ayant un degré de saponification de 91 % en mole ou davantage est de 45 à 95 % en masse par rapport à la quantité totale de matière solide de la couche de protection, dans lequel la teneur du copolymère d'oxyde d'éthylène et d'oxyde de propylène contenus dans la couche de protection est de 2,0 à 15 % en masse par rapport à la quantité totale de matière solide de la couche de protection, et dans lequel une quantité de revêtement de la couche de protection est de 0,3 à 3,0 g/m² et
dans lequel la couche photosensible contient un agent absorbant l'infrarouge, un initiateur de polymérisation, un composé polymérisable, et un polymère de liaison.

2. Précurseur de plaque d'impression planographique selon la revendication 1, dans lequel une teneur d'oxyde d'éthylène contenu dans le copolymère d'oxyde d'éthylène et d'oxyde de propylène contenus dans la couche de protection est de 30 à 80 % en masse.

3. Précurseur de plaque d'impression planographique selon l'une quelconque des revendications 1 à 2, dans lequel la perméabilité à l'oxygène de la couche de protection dans l'environnement de 25 °C, 65 % HR et 1 atm est de 0,5 ml/m² par jour à 100 ml/m² par jour.

4. Précurseur de plaque d'impression planographique selon la revendication 1 à 3, dans lequel le polymère de liaison contenu dans la couche photosensible est un polymère de liaison ayant une unité répétitive représentée par la formule (i) suivante : 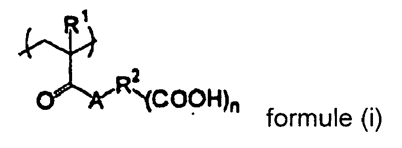 dans la formule (i), R¹ représente un atome d'hydrogène ou un groupe méthyle, R² représente un groupe d'attachement contenant 2 ou plusieurs atomes sélectionnés dans le groupe constitué par un atome de carbone, un atome d'hydrogène, un atome d'oxygène, un atome d'azote et un atome de soufre et ayant le nombre de ces atomes allant de 2 à 82, A représente un atome d'oxygène ou -NR³-, R³ représente un atome d'hydrogène ou un groupe hydrocarboné monovalent ayant un nombre de carbones de 1 à 10, et n représente un nombre entier de 1 à 5.
